# EUROPEAN PATENT APPLICATION

(11) **EP 3 889 003 A1**
(43) Date of publication of application: **06.10.2021**
(21) Application number: 21164250.9
(22) Date of filing: 23.03.2021
(51) Int. Cl.: B62B 9/14, B62B 9/00, B62B 9/20, B62B 7/00, B62B 9/08, B62B 7/14, B62B 3/00, B62B 5/00, B62B 5/04

(54) **SMART STROLLER AND METHOD OF CONTROLLING THE SAME**

(30) Priority: 01.04.2020 KR 20200039873
(71) Applicant: LG Electronics Inc., Seoul 07336 (KR)
(72) Inventor: LEE, Minjae, 06772 Seoul (KR); LEE, Soomi, 06772 Seoul (KR); WON, Hyojin, 06772 Seoul (KR); KOH, Sunggyu, 06772 Seoul (KR); SEO, Kyunghye, 06772 Seoul (KR); LEE, Minjong, 06772 Seoul (KR); LEE, Younsung, 06772 Seoul (KR); KIM, Sungpil, 06772 Seoul (KR); CHOI, Hanwool, 06772 Seoul (KR); SON, Hyojun, 06772 Seoul (KR); CHUNG, Jaiwhan, 06772 Seoul (KR)
(74) Representative: Vossius & Partner Patentanwälte Rechtsanwälte mbB

(57) **Abstract**

The present disclosure relates to a smart stroller and a method of controlling the same. The smart stroller includes a sensor part configured to sense various information regarding a space in which a baby is seated and information regarding the surrounding environment in which the smart stroller is traveling. The sensed information is transmitted to a controller so as to be calculated as information for controlling operation of the smart stroller or information for informing to a user. This may enable the smart stroller to travel in a stable manner. This may also allow the user to check the state of the baby in real time and take necessary action.

## Description

### TECHNICAL FIELD

The present disclosure relates to a smart stroller and a method of controlling the same. More particularly, the present disclosure relates to a smart stroller that can allow a user to easily recognize information regarding an environment in which the smart stroller is traveling and reduce an amount of force required for making the smart stroller travel, and a method of controlling the same.

### BACKGROUND

A toddler refers to a young child. Since toddlers have not completed their growth and development, they can be easily injured by external force.

For this reason, a variety of devices for protecting the toddlers when at home and outside are popularly sold.

For example, a stroller or baby carriage is widely used when going out with a toddler. A space in which a toddler or small child can ride is provided in a stroller. The toddler seated in the space can be transported as the stroller is moved by force applied by a user.

A stroller may travel in various environments or situations. For example, the stroller may travel in a high temperature environment or in an environment with high concentration of fine dust. Or, the stroller may travel in a non-flat road environment such as a slope.

In the case of the conventional stroller, a user who uses the stroller (i.e., a guardian or parent) checks the surrounding environment with the naked eye. Thus, the user has to decide a traveling method or the like by himself or herself according to changes in environment in which the stroller is traveling.

However, in such a stroller, traveling of the stroller is only determined by information identified by the user using the five senses including the naked eye. That is, accuracy of information that is easily identified by the naked eye, such as a slope, can be guaranteed, but accuracy of information that is difficult to identify with the naked eye, such as a temperature, humidity, and fine dust concentration, cannot be ensured.

Further, it is under the premise that a baby is seated in the stroller. Information recognized by the user, which is information recognized by the user exposed to an external environment, may be different from information regarding a space in which the baby is seated.

Therefore, even if the user recognizes information regarding the external environment and takes necessary action, it may be difficult to say that the environment around the baby is effectively improved.

Korean Laid-Open Patent Application No. 10-2017-0058085, which is hereby incorporated by reference, discloses an unmanned autonomous driving baby carriage and a method of controlling the same. In this publication, pattern driving information is generated using baby state information generated by sensing the state of a baby or surrounding information generated by sensing the surroundings.

However, such an autonomous unmanned driving baby carriage has a limitation in that sensed information and information calculated based on it are abstract. That is, it may be difficult to say that the baby state information disclosed in the related art document, such as a bowel movement, hungriness, and the like of the baby, is information that can be used for taking immediate action.

Moreover, it may be difficult to say that the surrounding information, such as a toilet, a restaurant, or a pediatric clinic, disclosed in the related art document, is directly affect traveling of the stroller. Therefore, the related art document only discloses a method for caring a baby, which fails to provide a method for improving traveling convenience of the baby carriage itself.

Korean Registered Patent Application No. 10-1006692, which is hereby incorporated by reference, discloses a baby carriage having an internal temperature sensing and real-time growth check computing functions and an operation method thereof. In this publication, physical growth and development of a baby is checked by receiving information regarding personal information (e.g., name, gender, etc.) and physical conditions of the baby, and checking results are provided to a user.

In such a baby carriage, information regarding a baby's growth and development can be provided, however information regarding real-time changes in the state of the baby cannot be provided.

Further, a method for improving traveling convenience of the baby carriage in which the baby is seated is not provided in the related art document.

### [Related Art Documents]

### [Patent Documents]

Korean Laid-Open Patent Application No. 10-2017-0058085 (July 08, 2017)
Korean Registered Patent Application No. 10-1006692 (January 10, 2011)

### SUMMARY

The present disclosure describes a smart stroller that can solve the aforementioned problems, and a method of controlling the same.

The present disclosure also describes a smart stroller that can reduce an amount of force required for a user to make the smart stroller to travel, and a method of controlling the same.

The present disclosure also describes a smart stroller that can be easily manipulated by a user, and a method of controlling the same.

The present disclosure also describes a smart stroller that can improve the safety of a baby seated in the stroller, and a method of controlling the same.

The present disclosure also describes a smart stroller that can be controlled to travel according to terrain condition of an area to be travelled by the stroller, and a method of controlling the same.

The present disclosure also describes a smart stroller that can allow a baby to breathe in clean air regardless of air quality in an area where the stroller is located, and a method of controlling the same.

The present disclosure also describes a smart stroller that can allow a user to immediately recognize or check the state of a baby in the stroller to take necessary action, and a method of controlling the same.

According to one aspect of the subject matter described in this application, a smart stroller includes: a baby seat unit provided therein with a space and including an air cleaning module configured to purify air in the space; and a cart unit that supports the baby seat unit. The cart unit includes: a base portion that extends in one direction; main wheels rotatably coupled to a lower part of the base portion; a motor that is connected to the main wheels so as to be rotated together with the main wheels; a vertical portion that extends in an up-and-down direction at an upper side of the base portion; a handle that is rotatably coupled to an upper part of the vertical portion; a pressure sensor that is connected to the handle and the vertical portion and senses information regarding a direction or strength of force applied to the handle; and a controller that is electrically connected to the motor and the pressure sensor, so as to receive the sensed information and calculate operation information regarding operation of the cart unit using the received information.

Implementations according to this aspect may include one or more of the following features. For example, the cart unit further may include: a pressure sensor accommodating portion that is connected to the handle and the vertical portion and accommodates the pressure sensor in a space formed therein; and a manipulation portion that is rotatably coupled to the vertical portion and the pressure sensor accommodating portion, is electrically connected to the controller, and receives the operation information when being rotated.

In some implementations, the cart unit may further include a seat support portion that is coupled to the vertical portion at a lower side of the handle and supports the baby seat unit. The baby seat unit and the cart unit may be electrically connected to each other when the baby seat unit is placed on the seat support portion, and the manipulation portion may receive operation information for controlling operation of the air cleaning module when being rotated.

In some implementations, the manipulation portion may receive operation information for controlling operation of the motor when being rotated.

In some implementations, the manipulation portion may include a concave and convex portion formed on an outer circumferential surface thereof.

In some implementations, the cart unit of the smart stroller may further include a display that is provided at an upper end of the vertical portion and is electrically connected to the controller so as to output the calculated operation information.

In some implementations, the handle may be provided therein with a space. A touch sensor part that senses information regarding a distance or contact between the handle and an object and is electrically connected to the controller may be mounted to the space, and the controller may calculate operation information regarding rotation of the motor using the information sensed by the touch sensor part.

In some implementations, the cart unit may further include a dust sensor that is located adjacent to an upper end of one surface of the vertical portion facing the one direction in which the base portion extends, among surfaces of the vertical portion, and the dust sensor may be electrically connected to the controller and sense dust information regarding dust concentration in a preset space having a predetermined area with respect to the cart unit.

In some implementations, the baby seat unit may include: a temperature sensor configured to sense information regarding a temperature of the space; a humidity sensor configured to sense information regarding humidity of the space; and an air sensor configured to sense information regarding an operation state of the air cleaning module. The temperature sensor, the humidity sensor, and the air sensor may be electrically connected to the controller.

In some implementations, the cart unit may further include a terrain sensor that is located at an end, of ends in the direction in which the base portion extends, of one side opposite to the vertical portion and is electrically connected to the controller. The terrain sensor may sense terrain information regarding terrain at the one side.

In some implementations, the cart unit may further include a battery that is electrically connected to the controller and the baby seat unit to supply power, and a voltage sensor that is electrically connected to the battery to sense voltage information regarding a voltage of the battery and is electrically connected to the controller.

According to another aspect, a method of controlling a smart stroller includes the steps of: (a) sensing, by a sensor part, information regarding operation;(b) sensing, by the sensor part, information regarding a surrounding environment of the smart stroller; (c) calculating, by a controller, operation information using the sensed information regarding the operation of the smart stroller or the sensed information regarding the surrounding environment of the smart stroller; (d) controlling, by the controller, the smart stroller according to the calculated operation information; and (e) outputting, by a display, the sensed information or the calculated operation information.

Implementations according to this aspect may include one or more of the following features. For example, the step (a) may include: (a1) sensing, by a touch sensor, information regarding a distance between a handle and an object; (a2) sensing, by a pressure sensor, information regarding information regarding a direction or strength of force applied to the handle; and (a3) sensing, by a voltage sensor, information regarding a voltage of a battery.

In some implementations, the step (b) may include: (b1) sensing, by a terrain sensor, information regarding terrain in a traveling direction of the smart stroller; (b2) sensing, by a dust sensor, information regarding dust concentration in the surrounding environment of the smart stroller; and (b3) sensing, by a seat sensor, information regarding air in a space in which a baby is seated.

In some implementations, the step (c) may include: (c1) calculating, by a touch information calculation module, touch information regarding whether or not the handle is gripped using information sensed by a touch sensor; (c2) calculating, by a traveling information calculation module, traveling information regarding traveling of the smart stroller using information sensed by a pressure sensor and information sensed by a voltage sensor; (c3) calculating, by an environment information calculation module, environment information regarding the surrounding environment of the smart stroller by using information sensed by a terrain sensor and information sensed by a dust sensor; and (c4) calculating, by an internal information calculation module, internal information regarding air of a space in the baby seat unit using information sensed by a seat sensor; and (c5) calculating, by an operation calculation module, operation information by using at least one of the calculated touch information, the traveling information, the environment information, and the internal information.

In some implementations, the step (d) may include: (d1) controlling, by a brake control unit, a brake to be operated or released according to the calculated operation information; (d2) controlling, by a motor control unit, a motor to rotate or stop according to the calculated operation information; (d3) controlling, by a suspension control unit, a suspension such that a damping force of the suspension is adjusted according to the calculated operation information; and (d4) controlling, by an air cleaning control unit, an air cleaning module provided at a baby seat unit according to the calculated operation information.

In some implementations, the step (e) may include: (e1) outputting, by the display, information regarding a voltage of a battery, among the sensed information; (e2) outputting, by the display, information regarding air in a space in which a baby is seated, among the sensed information; (e3) outputting, by the display, information regarding operation of a brake, among the calculated operation information; and (e4) outputting, by the display, information regarding operation of the air cleaning module, among the calculated operation information.

In some implementations, the method of controlling the smart stroller may further include, before the step (d): (f) receiving, by a manipulation portion, operation information regarding operation of the smart stroller when being rotated. The step (f) may include: (f1) receiving, by a first manipulation portion, operation information regarding operation of a motor when being rotated; and (f2) receiving, by a second manipulation portion, operation information regarding operation of an air cleaning module when being rotated. The step (d) may include: (d5) controlling, by a motor control unit, the motor to rotate or stop according to input operation information; and (d6) controlling, by an air cleaning control unit, the air cleaning module provided at a baby seat unit according to input operation information.

The implementations of the present disclosure may provide at least one or more of the following benefits.

A smart stroller according to the present disclosure is equipped with a pressure sensor. The pressure sensor may sense pressure information regarding a direction and strength of force applied by a user. The sensed pressure information may be transmitted to a controller, so as to be used to calculate operation information for controlling a motor.

According to the calculated operation information, the motor may be rotated such that the smart stroller travels in a direction in which force is applied by the user.

Thus, an amount of force required for the user to make the smart stroller travel may be reduced.

In addition, a manipulation portion may be provided between a handle gripped by the user and a vertical portion that defines a vertical body of a cart unit. The manipulation portion may be rotatably coupled to the vertical portion. The user may rotate the manipulation portion to input operation information for controlling the smart stroller.

As the manipulation portion is located adjacent to the user's hands holding the handle, the user may easily input operation information. In addition, as the manipulation portion receives operation information in a rotatable manner, the user may easily input operation information and instantly recognize the input operation information.

A touch sensor may be provided on the handle gripped by the user. The touch sensor may control a brake to be released so as to allow main wheels to rotate only when it is calculated (or determined) that the handle is gripped by the user. When the user is taking his or her hands off from the handle, the brake may be operated to inhibit the main wheels from rotating.

As the smart stroller is allowed to travel only when the handle is gripped by the user, safety of a baby seated in the smart stroller may be improved.

A terrain sensor may be provided in the cart unit. The terrain sensor may be located at the front side of the cart unit to sense terrain information regarding terrain of an area to be travelled by the smart stroller. The sensed information may be transmitted to the controller, so as to be used to calculate operation information for controlling the motor and a suspension.

Accordingly, a rotation direction and a rotation speed of the motor may be controlled according to an inclination (or tilt) of the area or irregularities on the road surface ahead of the smart stroller. In addition, a damping force of the suspension may be adjusted depending on the presence and absence of irregularities on the road surface ahead of the smart stroller. Since the smart stroller is controlled according to terrain of the area ahead and the like, the user may easily push the smart stroller to travel.

An air sensor may be provided in a baby seat unit, and a dust sensor may be provided in the cart unit. The dust sensor may sense dust concentration in air to be introduced into an inner space of the baby seat unit, and the air sensor may sense dust concentration in air to be introduced into the space. The dust concentration sensed by the dust sensor and the air sensor may be transmitted to the controller, so as to be used to calculate operation information for controlling an air cleaning module.

The air cleaning module may be controlled to adjust an amount of air to be purified according to the calculated operation information.

As an operation speed of the air cleaning module is controlled according to the dust concentration in an area where the smart stroller is located, the baby can breathe in clean air.

A display may be electrically connected to a sensor part and the controller. The display may output information sensed by the sensor or information calculated by the controller as visualization information.

The display may be located at an upper end of the vertical portion to which the handle is rotatably coupled. Accordingly, the user may recognize information output to the display by simply moving his or her gaze while holding the handle.

Therefore, the user may immediately check the state of a baby in the smart stroller and take necessary action. This may result in improving user convenience and safety of the baby.

### BRIEF DESCRIPTION OF THE DRAWINGS

FIG. 1 is a perspective view illustrating an example of a smart stroller;
FIG. 2 is a perspective view illustrating a state in which a baby seat unit and a cart unit of the smart stroller of FIG. 1 are separated from each other;
FIG. 3 is a perspective view of the baby seat unit provided in the smart stroller of FIG. 1;
FIG. 4 is a perspective view of the baby seat unit of FIG. 3 seen from a different angle;
FIG. 5 is a perspective view of the cart unit provided in the smart stroller of FIG. 1;
FIG. 6 is an enlarged perspective view illustrating an upper side of the cart unit of FIG. 5;
FIG. 7 is a partially-cut perspective view illustrating an internal configuration of the cart unit of FIG. 5;
FIG. 8 is a perspective view illustrating an internal configuration of a handle of the cart unit of FIG. 5;
FIG. 9 is a perspective view of a sensor provided at a base portion of the cart unit of FIG. 5;
FIG. 10 is a block diagram illustrating a configuration for implementing an example method of controlling a smart stroller;
FIG. 11 is a perspective view illustrating a flow of an example method of controlling a smart stroller;
FIG. 12 is a flow chart illustrating a detailed flow of a step S100 of FIG. 11;
FIG. 13 is a flow chart illustrating a detailed flow of a step S200 of FIG. 11;
FIG. 14 is a flow chart illustrating a detailed flow of a step S300 of FIG. 11;
FIG. 15 is a flowchart illustrating a detailed flow of a step S400 of FIG. 11;
FIG. 16 is a flow chart illustrating a detailed flow of a step S500 of FIG. 11;
FIG. 17 is a flowchart illustrating a detailed flow of a step S600 of FIG. 11; and
FIG. 18 is a schematic view illustrating a state in which operation information is output to a display provided at the cart unit of FIG. 5.

### DETAILED DESCRIPTION

Hereinafter, one or more examples of a smart stroller and a method of controlling the same will be described in detail with reference to the accompanying drawings.

In the following description, description of several components will be omitted in order to clarify the technical features of the present disclosure.

### 1. Definition of Terms

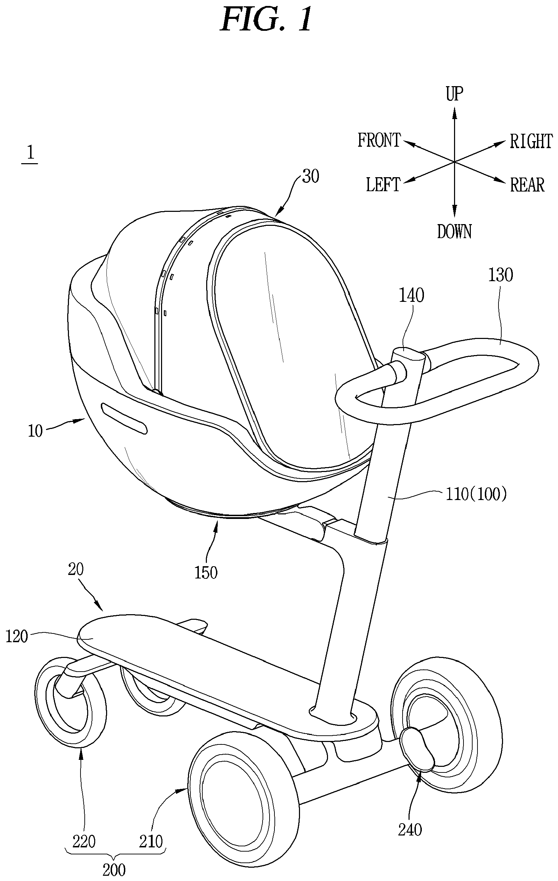

The terms "front side (or part)", "rear side", "left side", and "right side", "upper side", and "lower side" as used herein will be understood with reference to a coordinate system shown in FIG. 1 It will be understood that these directions are set based on a traveling or moving direction of a smart stroller 1.

The term "infant" used herein refers to a very young child who cannot walk completely independently. For example, an infant can be used to refer to any child under a year old.

The term "toddler" used herein refers to a young child who is learning or has recently learned to walk, or can be transported with a baby carrier or the like even if he or she is capable of walking independently. For example, a toddler can be used to refer to any child from 1 to 4 years old.

Hereinafter, the "infant" and "toddler" will be collectively referred to as a "baby", an encompassing term for infants and toddlers.

The term "seat unit" used herein refers to an object having a space in which infants or toddlers can ride or seat. In some implementations, the seat unit may be detachably coupled to a cradle unit provided in a vehicle, or a cart unit that can travel independently.

The term "electrical connection" may be used when two or more members are connected in a manner of allowing an electrical signal, power, and the like to be transmitted. For example, the electrical connection may be achieved in a wired or wireless manner.

### 2. Description of Configuration of Example Smart Stroller 1

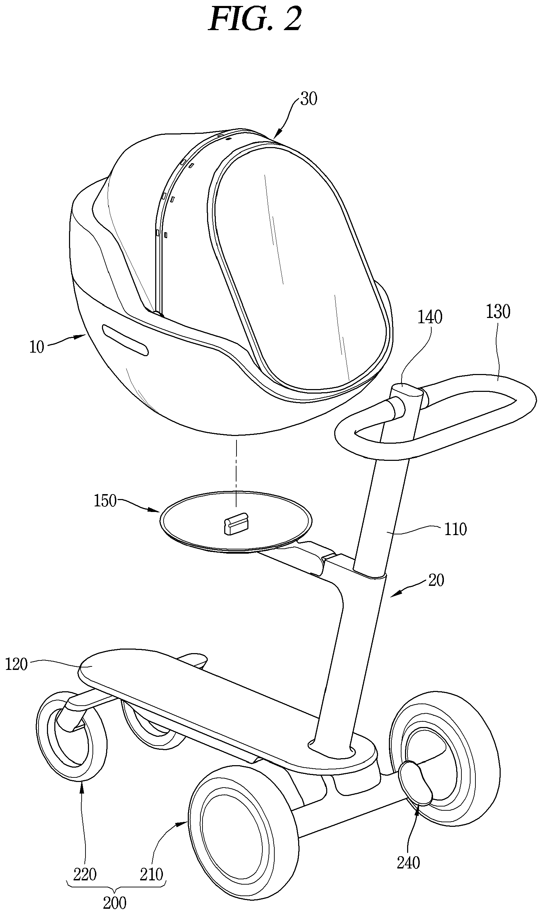

FIG.1 illustrates a state in which a baby seat unit (or stroller seat) 10 is coupled to a cart unit (or cart) 20, and FIG.2 illustrates a state in which the baby seat unit 10 is separated from the cart unit 20. The smart stroller 1 may be configured by a combination of the baby seat unit 10 and the cart unit 20.

In the depicted example, the baby seat unit 10 may be coupled to the cart unit 20 in a detachable manner. This may be achieved by an elastic force applied by a spring (not shown) or the like.

In some implementations, the baby seat unit 10 that is detachably coupled to the cart unit 20 may be electrically connected to the cart unit 20. Accordingly, power supplied from a battery 180 of the cart unit 20 may be transmitted to the baby seat unit 10.

The cart unit 20 may travel indoors or outdoors. In detail, the cart unit 20 may travel indoors or outdoors as a wheel part 200 is rotated by force applied by a user through a handle 130.

Hereinafter, the constituting elements (or components) of the smart stroller 1 will be described in detail with reference to the accompanying drawings.

### (1) Description of Baby Seat Unit 10

As illustrated in FIGS. 1 and 2, the smart stroller 1 includes the baby seat unit 10.

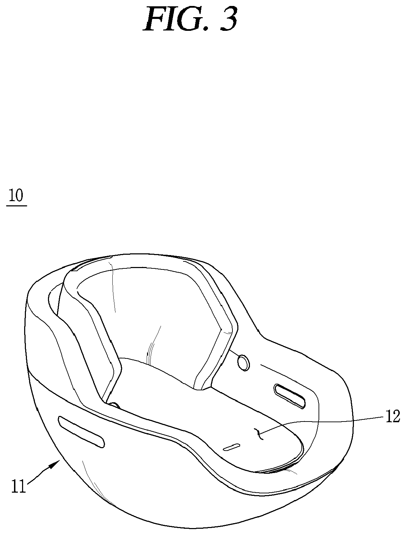

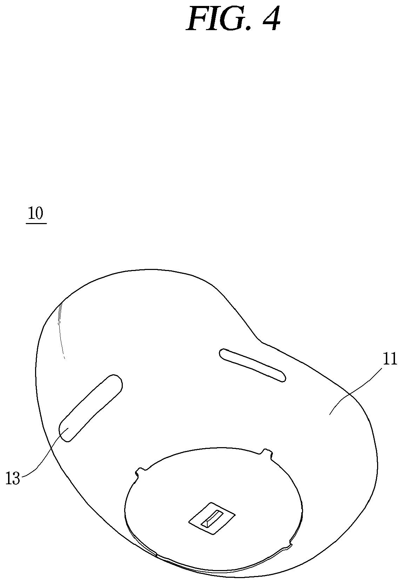

Hereinafter, the baby seat unit 10 according to implementations of the present disclosure will be described in detail with reference to FIGS. 3 and 4.

A baby may ride or seat in the baby seat unit 10. A predetermined space is formed inside the baby seat unit 10.

The baby seat unit 10 has a substantially sphere shape with an open upper side or part. Lower and front sides of the baby seat unit 10 are rounded.

The upper side of the baby seat unit 10 is open. The baby seat unit 10 may be provided therein with a predetermined space in which a baby is accommodated.

In the depicted example, the baby seat unit 10 has a symmetrical shape. Accordingly, there may be no distinction between the left and right directions of the baby seat unit 10. This may result in improving user convenience.

As illustrated in FIG. 2, the baby seat unit 10 may be detachably coupled to the cart unit 20. When the baby seat unit 10 is coupled to the cart unit 20, the baby seat unit 10 may be electrically connected to the cart unit 20.

This is under the premise that the baby seat unit 10 is moved in a state that a baby is seated thereon. That is, in order to reduce weight of the baby seat unit 10, a battery and the like for electrical connection may be, preferably, provided in the cart unit 20.

In addition, an air cover 30 may be detachably coupled to the baby seat unit 10. The air cover 30 may filter air flowing into the inner space of the baby seat unit 10 through physical and electrostatic attraction.

Accordingly, air from which fine dust and the like have been removed is introduced into the inner space of the baby seat unit 10, allowing the baby to breathe in clean air.

In the depicted example, the baby seat unit 10 includes a seat body portion (or seat body) 11, a seat space portion (or seat space) 12, and an air cleaning module 13.

The seat body portion 11 defines a body of the baby seat unit 10. The seat body portion 11 is configured to hold a baby seated therein.

The seat body portion 11 may be made of a material that is lightweight and high rigidity (or stiffness). In some implementations, the seat body portion 11 may be made of reinforced plastics.

A cart coupling portion is formed at one side of the seat body portion 11 facing the cart unit 20, namely, the lower side in the illustrated example. The cart coupling portion may be provided therein with a recessed space in which a coupling member provided at a seat support portion 150 of the cart unit 20 is inserted.

When the seat body portion 11 is placed or mounted on the seat support portion 150, the baby seat unit 10 and the cart unit 20 are electrically connected to each other. Various electronic devices provided in the baby seat unit 10 may be operated by power supplied from the cart unit 20.

The seat body portion 11 is provided therein with the seat space portion 12 in which a baby is seated. In addition, the air cleaning module 13 is coupled to one side of the seat body portion 11 that is opposite to the cart unit 20, namely, to the front side in the illustrated example.

The seat space portion 12 is a space in which a baby is seated. The seat space portion 12 may be defined as a space that is surrounded by the seat body portion 11.

A mounting portion is provided at a lower side of the seat space portion 12. The baby seated in the seat space portion 12 may be supported by the mounting portion.

The seat space portion 12 is surrounded by the seat body portion 11. Accordingly, the baby seated in the seat space portion 12 may be securely seated in the seat space portion 12.

The seat space portion 12 communicates with an external space. The baby may be accommodated in the seat space portion 12 through the space.

The seat space portion 12 communicates with the air cleaning module 13. Air inside the seat space portion 12 may flow to the air cleaning module 13 to be purified and then flow back to the seat space portion 12.

A seat sensor 360 may be provided inside the seat support portion 12. The seat sensor 360 may sense information regarding a temperature, humidity, and air inside the seat space portion 12.

This may allow the baby to always breath in clean air.

The air cleaning module 13 purifies air flowing in the seat space portion 12. The baby seated in the seat space portion 12 may breathe in air purified by the air cleaning module 13.

The air cleaning module 13 communicates with the seat space portion 12. Air inside the seat space portion 12 may flow to the air cleaning module 13. Also, air purified by the air cleaning module 13 may flow into the seat space portion 12.

The air cleaning module 13 is coupled to the seat body portion 11. In the depicted example, the air cleaning module 13 may be coupled to one side of the seat body portion 11 that is opposite to the cart unit 20, namely, to the front side in the illustrated example.

The air cleaning module 13 may be detachably coupled to the seat body portion 11. Accordingly, the user may easily separate the air cleaning module 13 from the seat body portion 11 when replacing consumables provided in the air cleaning module 13, such as a filter, or repairing the air cleaning module 13.

The air cleaning module 13 may be electrically connected to the cart unit 20. The air cleaning module 13 may be powered by the battery 180 provided in the cart unit 20.

### (2) Description of Cart Unit 20

As illustrated in FIGS. 1 and 2, the smart stroller 1 includes the cart unit 20.

The cart unit 20 may travel indoors or outdoors. This is achieved by the wheel part 200 provided at the cart unit 20.

The baby seat unit 10 may be detachably coupled to the cart unit 20. More specifically, the baby seat unit 10 is detachably coupled to the seat support portion 150 of the cart unit 20.

The baby seat unit 10 mounted to the cart unit 20 may receive power from the cart unit 20. Accordingly, it may be considered that the baby seat unit 10 is eclectically connected to the cart unit 20.

The cart unit 20 may include the battery 180. The battery 180 supplies power for operating the cart unit 20. In some implementations, a motor 230 and the like accommodated in the cart unit 20 may be operated by the battery 180 in response to a signal applied to a display 140 located adjacent to the handle 130.

In addition, the battery 180 may supply power to the baby seat unit 10 that is electrically coupled to the cart unit 20. This may allow the air cleaning module 13 or an LED (not shown) provided at the baby seat unit 10 to emit light.

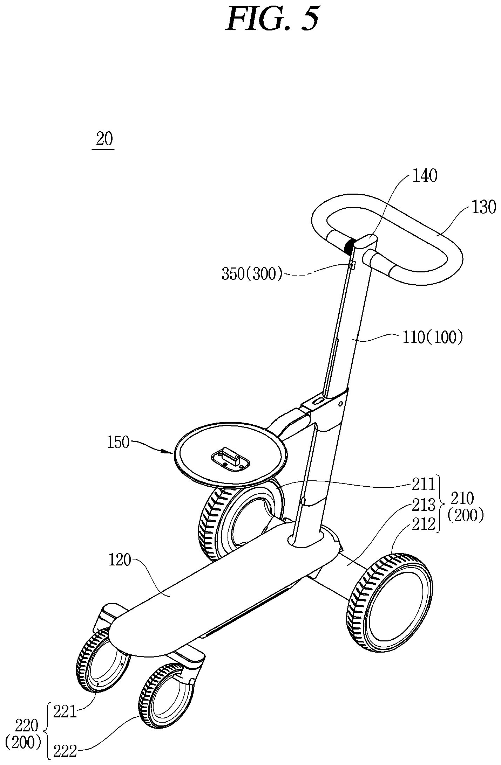

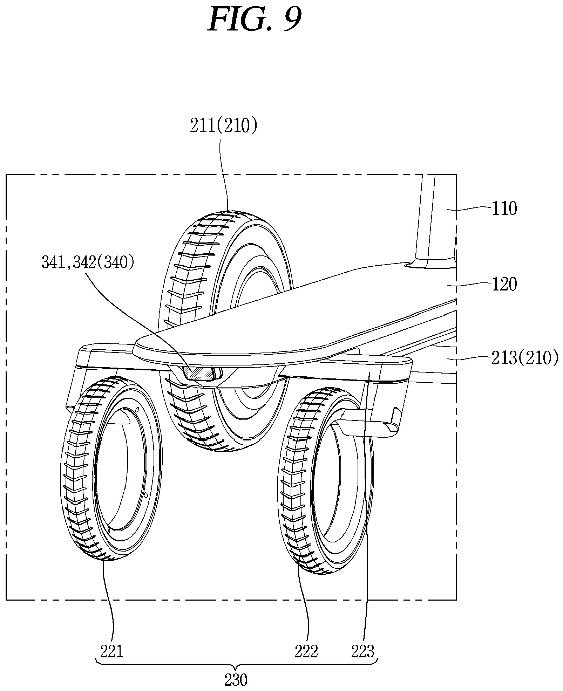

Referring to FIGS. 5 and 9, the cart unit 20 includes a body part (or body) 100 and the wheel part 200.

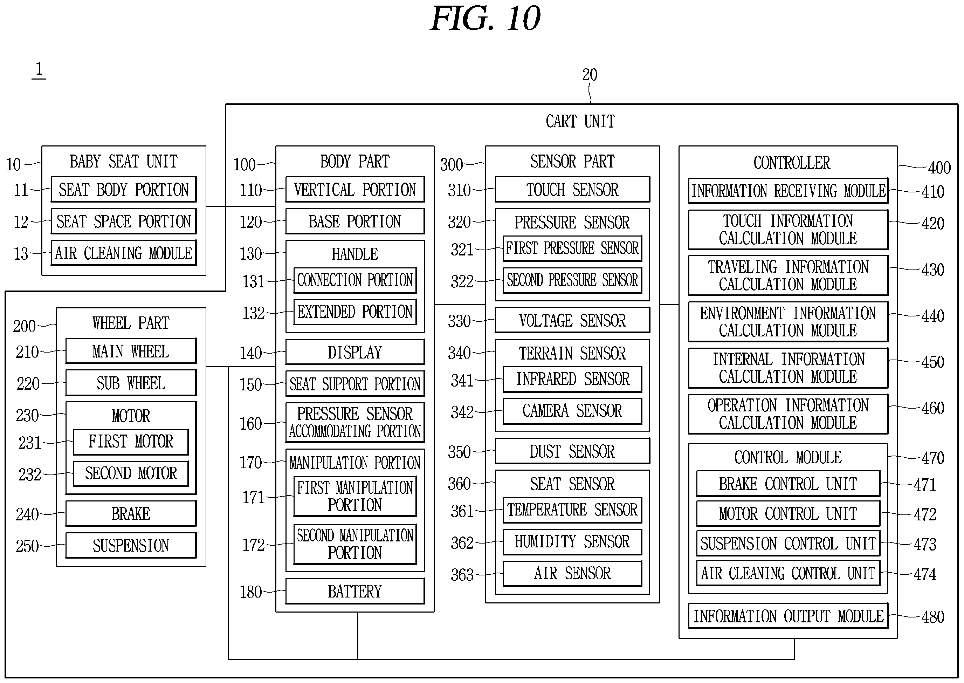

Referring to FIG. 10, the cart unit 20 further includes a sensor part (or sensor) 300 and a controller 400.

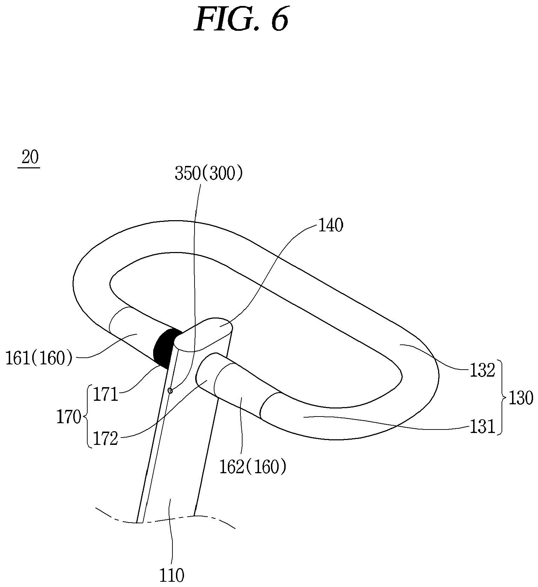

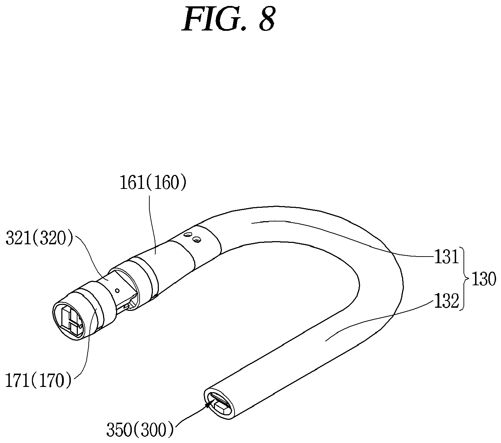

Hereinafter, the constituting elements (components) of the cart unit 20 will be described in detail with reference to FIGS. 5 to 9, but the sensor part 300 and the controller 400 will be described separately.

### 1) Description of Body Part 100

The body part 100 defines a body structure (or framework) of the cart unit 20. The body part 100 is a portion of the cart unit 20 that is exposed to the outside. Accordingly, each corner of the body part 100 may be chamfered to prevent the user from being injured.

The body part 100 may be made of a material that is lightweight and high rigidity. In some implementations, the body part 100 may be made of reinforced plastics.

The body part 100 includes a vertical portion 110, a base portion 120, the handle 130, the display 140, the seat support portion 150, a pressure sensor accommodating portion 160, a manipulation portion 170, and the battery 180 (see FIG. 10).

The vertical portion 110 defines a vertical body structure of the body part 100. The vertical portion 110 extends in a direction toward the ground and a direction away from the ground, namely, in an up-and-down direction of the illustrated example.

The vertical portion 110 may extend in the up-and-down direction to be inclined or tilted with respect to the ground by a predetermined angle. In some implementations, the vertical portion 110 may extend to be inclined toward a direction in which the user holds or grips the handle 130, that is, the vertical portion 110 may extend to be inclined rearward in the illustrated example.

Accordingly, the vertical portion 110 may extend to be inclined toward the user to thereby enhance user convenience.

The vertical portion 110 may have a polygonal prism shape with a predetermined thickness. In the depicted example, the vertical portion 110 has a square prism shape with a longer side in a front-and-rear (or back-and-forth) direction and a shorter side in a left-and-right direction.

Each corner of the vertical portion 110 may be chamfered or rounded. This may prevent the user from being injured by the vertical portion 110.

The base portion 120 is coupled to one side of the vertical portion 110 that faces the ground, namely, the lower side in the illustrated example. In some implementations, the vertical portion 110 may be folded in a direction to the base portion 120.

Accordingly, a space occupied by the cart unit 20 may be minimized while not in use.

The handle 130 is coupled to another side of the vertical portion 110 that is directed opposite to the ground, namely, the upper side in the illustrated example. In some implementations, the handle 130 may be rotatably couped to the vertical portion 110.

Accordingly, the handle 130 may be rotated according to a body shape of the user, so as to be adjusted to an angle that is most suitable for the user to hold.

An elevating portion (no reference numeral) that is connected to the seat support portion 150 is penetratingly coupled to one position of the vertical portion 110 that is located between the base portion 120 and the handle 130.

The elevating portion may be moved in a direction toward the handle 130 or a direction away from the handle 130 while being coupled to the vertical portion 110. In other words, the elevating portion may be moved in the up-and-down direction while being coupled to the vertical portion 110.

Accordingly, the user may adjust a height of the baby seat unit 10 by adjusting a height of the elevating portion.

A dust sensor 350 of the sensor part 300 is provided at one side of the vertical portion 110 facing the seat support portion 150, namely, at the front side in the illustrated example. The dust sensor 350 may be located adjacent to an upper end of the vertical portion 110, namely, adjacent to the display 140.

The base portion 120 defines a lower body structure of the cart unit 20 in a horizontal direction. The base portion 120 extends in a direction toward and a direction away from the vertical portion 110, namely, in the front-and-rear direction in the illustrated example.

In some implementations, the base portion 120 may horizontally extend with respect to the ground. Accordingly, the user may put personal belongings like a bag on the base portion 120.

The base portion 120 may have a board shape. In the depicted example, front and rear corners of the base portion 120 are rounded. The base portion 120 may have a shape that allows the vertical portion 110 to be coupled thereto and allows the wheel part 200 to be rotatably coupled thereto.

Accordingly, personal belongings and the like carried by the user may be put and placed on the base portion 120.

Each corner of the base portion 120 may be chamfered or rounded. This may prevent the user from being injured by the corners of the base portion 120.

The vertical portion 110 is coupled to one side of the base portion 120 that faces the vertical portion 110, namely, to the upper rear side in the illustrated example.

A main wheel support portion 213 is coupled to another side of the base portion 120 that is directed opposite to the vertical portion 110, namely, to the lower rear side in the illustrated example. In addition, a sub wheel support portion 223 is rotatably coupled to the another side of the base portion 120, namely, to the lower front side in the illustrated example.

A terrain sensor 340 of the sensor part 300 may be provided at another side of the base portion 120 opposite to the vertical portion 110, namely, at the front side in the illustrated example.

The handle 130 is a portion gripped by the user to enable the cart unit 20 to travel. The user may push or pull the handle 130 to make the cart unit 20 move forward or backward.

The handle 130 is disposed at the vertical portion 110. In detail, the handle 130 is located at one side of the vertical portion 110 opposite to the base portion 120, namely, at the upper side in the illustrated example.

The handle 130 may be rotatably coupled to the vertical portion 110. Accordingly, the user may rotate the handle 130 according to his or her height to comfortably hold the handle 130. In addition, the user may rotate the handle 130 toward the front side of the vertical portion 110 to reduce volume of the cart unit 20 while not in use.

The handle 130 may be coupled to both sides of the vertical portion 110 to face each other. In the depicted example, the handle 130 may be rotatably coupled to left and right sides of the vertical portion 110.

The pressure sensor accommodating portion 160 and the manipulation portion 170 are located between the handle 130 and the vertical portion 110. That is, the manipulation portion 170 is rotatably coupled to the vertical portion 110. In addition, the pressure sensor accommodating portion 160 is rotatably coupled to the manipulation portion 170, and the handle 130 is rotatably coupled to the pressure sensor accommodating portion 160.

In other words, the handle 130, the pressure sensor accommodating portion 160 that is located between the handle 130 and the vertical portion 110, and the manipulation portion 170 may be rotated relative to one another.

The handle 130 may be divided into two portions. That is, the handle 130 may include a connection (or connecting) portion 131 that is connected to the vertical portion 110 and having sides disposed to face each other, and an extended potion 132 that is continuous with the connecting portion 131 and extends at a rear side of the vertical portion 110.

The connection portion 131 is rotatably coupled to the vertical portion 110. The pressure accommodating portion 160 and the manipulation portion 170 may be located between the connection portion 131 and the vertical portion 110. That is, the connection portion 131 is rotatably coupled to the pressure sensor accommodating portion 160.

A space is formed inside the connection portion 131. The space is in communication with a space formed inside the pressure sensor accommodating portion 160. A pressure sensor 320 of the sensor part 300 may extend from the vertical portion 110 to the space formed in the connection portion 131 by penetrating through an inner space of the manipulation portion 170 and the inner space of the presser sensor accommodating portion 160.

A bearing (not shown) is located in the space formed inside the connection portion 131. In detail, the bearing (not shown) is rotatably coupled to one side of the space formed in the connection portion 131 facing the pressure sensor accommodating portion 160.

The connection portion 131 of the handle 130 may be provided in plurality.

The plurality of connection portions 131 may be disposed to face each other with the vertical portion 110 interposed therebetween. One end of the connection portion 131 at a side directed opposite to the vertical portion 110 is continuous with the extended portion 132 of the handle 130.

The extended portion 132 of the handle 130 may be rounded to be convex outward and extend in one direction. In the depicted example, a right part of the extended portion 132 of the handle 130 is rounded to be convex toward the right side. In addition, a left part of the extended portion 132 of the handle 130 is rounded to be convex toward the left side.

The left and right parts of the extended portion 132 of the handle 130 are continuous in the left-and-right direction at the rear side of the vertical portion 110. The user may manipulate the cart unit 20 by gripping the rear side of the extended portion 132.

Alternatively, the extended portion 132 may be defined as a portion that extends in the left-and-right direction at the rear side of the vertical portion 110. Here, each of the connection portions 131 may be formed such that one end thereof is rotatably connected to one of the pressure sensor accommodating portions 160 and is rounded outward, and another end thereof is connected to the extended portion 132.

A space is formed inside the extended portion 132. A touch sensor 310 of the sensor part 300 may be mounted to the space.

The display 140 is located adjacent to the handle 130.

The display 140 is a portion through which the user inputs operation information for controlling the smart stroller 1. In addition, the display 140 may output operation information that is input by the user and a result of controlling the smart stroller 1 according to the input operation information as visual information, etc.

Accordingly, the display 140 may be also referred to as a user interface (Ul) module.

The display 140 may be configured as any form that can receive operation information from the user. In some implementations, the display 140 may be configured as a touch panel, a push button, or the like.

The display 140 may be configured as any form that can output visual information. In some implementations, the display 140 may be configured as an LED lamp, an LED panel, an LCD lamp, an LCD panel, and the like.

The display 140 is electrically connected to the controller 400. Sensed information and information calculated by the controller 400 may be transmitted to the display 140. The display 140 may output received information.

The display 140 is disposed at the vertical portion 110. In the depicted example, the display 140 is located at the upper end of the vertical portion 110. As the display 140 is located between the connection portions 131 of the handle 130, the user may easily manipulate the display 140, or recognize displayed visual information.

The seat support portion 150 is a portion where the baby seat unit 10 is detachably coupled to the cart unit 20. The seat support portion 150 supports a lower side of the baby seat unit 10.

The seat support portion 150 is electrically connected to the baby seat unit 10. The baby seat unit 10 placed on the seat support portion 150 may be electrically connected to the cart unit 20.

The seat support portion 150 is electrically connected to the battery 180 provided in the cart unit 20. The electrical connection may be achieved by a conductor member (not shown) or the like.

Accordingly, power supplied by the battery 180 may be transferred to the baby seat unit 10 through the seat support portion 150.

The seat support portion 150 is located at one side of the vertical portion 110 opposite to the handle 130, namely, at the front side in the illustrated example. That is, the baby seat unit 10 placed on the seat support portion 150 may be located at the front side of the user who manipulates the cart unit 20.

Thus, the user can see the baby in the baby seat unit 10 while manipulating the cart unit 20.

The seat support portion 150 is coupled to the vertical portion 110 by a coupling member (no reference numeral). In some implementations, the coupling member may be rotated in a direction toward the vertical portion 110.

Accordingly, the seat support portion 150 may also be rotated toward the vertical portion 110. This may allow a space occupied by the cart unit 20 to be reduced while not in use.

The seat support portion 150 may be made of a lightweight and high rigidity material. In some implementations, the seat support portion 150 may be made of reinforced plastics.

The seat support portion 150 may have a shape that can securely support the baby seat unit 10 placed thereon. In the depicted example, the seat support portion 150 is formed as a part of a spherical surface that is convex downward.

This is due to the lower side of the baby seat unit 10 that is placed on the seat support portion 150 has a spherical shape. A shape of the seat support portion 150 may vary depending on a shape of the lower side of the baby seat unit 10.

The pressure sensor accommodating portion 160 accommodates the pressure sensor 320 therein. That is, the pressure sensor accommodating portion 160 serves as a housing of the pressure sensor 320. Accordingly, the pressure sensor 320 is not exposed to an outside of the cart unit 20.

The pressure sensor accommodating portion 160 may be rotatably coupled to the vertical portion 110 and the handle 130. In detail, one side of the pressure sensor accommodating portion 160 is rotatably coupled to the vertical portion 110 and another side thereof is rotatably coupled to the handle 130.

Here, as described above, the manipulation portion 170 may be rotatably coupled between the pressure sensor accommodating portion 160 and the vertical portion 110. That is, the pressure sensor accommodating portion 160 is rotatably coupled to the manipulation portion 170.

Accordingly, the handle 130 and the pressure sensor accommodating portion 160 may be rotated relative to each other. This relative rotation may be achieved by the bearing (not shown).

A predetermined space is formed inside the pressure sensor accommodating portion 160. The space may be formed through the pressure sensor accommodating portion 160 in a direction toward the vertical portion 110 and a direction toward the handle 130, namely, in the left-and-right direction in the illustrated example.

In other words, the pressure sensor accommodating portion 160 may have a cylindrical shape with a through-hole formed therein.

A portion or part of the pressure sensor 320 is accommodated in the space, namely, in the through-hole.

The pressure sensor accommodating portion 160 may be provided in plurality. The plurality of pressure sensor accommodating portions 160 may be disposed to face each other with the vertical portion 110 interposed therebetween.

In the depicted example, the pressure sensor accommodating portion 160 includes a first pressure sensor accommodating portion 161 located on the right side and a second pressure sensor accommodating portion 162 located on the left side.

The first pressure sensor accommodating portion 161 is rotatably coupled to a first manipulation portion 171 and the handle 130 at a right side of the vertical portion 110. The second pressure sensor accommodating portion 162 is rotatably coupled to a second manipulation portion 172 and the handle 130 at a left side of the vertical portion 110.

Here, the pressure sensor 320 accommodated in the pressure sensor accommodating portion 160 is not rotated irrespective of rotation of the pressure sensor accommodating portion 160. A detailed description of this will be given later.

The manipulation portion 170 receives input of operation information for operating the smart stroller 1 when being rotated by the user. The user may rotate the manipulation portion 170 to control operation of the air cleaning module 13 provided at the baby seat unit 10 or control rotation of the motor 230.

The manipulation portion 170 is electrically connected to a control module 470 of the controller 400. Operation information, which is input when the manipulation portion 170 is rotated by the user, may be transmitted to the control module 470.

One side of the manipulation portion 170 is rotatably coupled to the vertical portion 110. Thus, the manipulation portion 170 may be rotated relative to the vertical portion 110.

Another side of the manipulation portion 170 is rotatably coupled to the pressure sensor accommodating portion 160. The manipulation portion 170 may be rotated relative to the pressure sensor accommodating portion 160.

A space may be formed inside the manipulation portion 170. The space may be formed through an inside of the manipulation portion 170 in a direction in which the manipulation portion 170 extends, namely, in the left-and-right direction in the illustrated example.

The pressure sensor 320 may be partially accommodated in the space. The pressure sensor 320 is not rotated even when the manipulation portion 170 is rotated.

In the depicted example, the manipulation portion 170 is formed in a cylindrical shape that has a circular cross section and extends in one direction, namely, in the left-and-right direction. The shape of the manipulation portion 170 may, preferably, be determined according to shapes of the pressure sensor accommodating portion 160 and the connection portion 131 of the handle 130.

Accordingly, the user may feel less difference or discomfort when gripping the handle 130, the pressure sensor accommodating portion 160, and the manipulation portion 170.

The manipulation portion 170 may be provided in plurality. The plurality of manipulation portions 170 may be disposed to face each other with the vertical portion 110 interposed therebetween. The plurality of manipulation portions 170 may be rotatably coupled to the vertical portion 110.

A concave and convex portion may be formed on an outer circumferential surface of the manipulation portion 170. The concave and convex portion may increase friction between the manipulation portion 170 and a hand of the user. This may allow the user to easily rotate the manipulation portion 170.

In the depicted example, the manipulation portion 170 includes the first manipulation portion 171 located on the right side and the second manipulation portion 172 located on the left side.

One side (left end in the drawings) of the first manipulation portion 171 is rotatably coupled to one side of the vertical portion 110, namely, to the right side in the illustrated example. Another side (right end in the drawings) of the first manipulation portion 171 is rotatably coupled to the first pressure sensor accommodating portion 161.

In some implementations, the first manipulation portion 171 may receive operation information for controlling rotation of the motor 230 when being rotated. The user may rotate the first manipulation portion 171 to input operation information for rotating the motor 230 according to a direction of force applied to the cart unit 20.

One side (right end in the drawings) of the second manipulation portion 172 is rotatably coupled to one side of the vertical portion 110, namely, to the left side in the illustrated example. Another side (left end in the drawings) of the second manipulation portion 172 is rotatably coupled to the second pressure sensor accommodating portion 162.

In some implementations, the second manipulation portion 172 may receive operation information for controlling the air cleaning module 13 provided at the baby seat unit 10 when being rotated. The user may rotate the second manipulation portion 172 to input operation information for operating the air cleaning module 13 to purify air in the inner space of the baby seat unit 10.

The battery 180 is electrically connected to each constituting element provided in the cart unit 20. The constituting elements may be powered by the battery 180. In some implementations, the battery 180 may be electrically connected to the display 140, the manipulation portion 170, the motor 230, a brake 240, a suspension 250, the sensor part 300, and the controller 400.

The battery 180 may be detachably coupled to the cart unit 20. The user may easily separate the battery 180 from the cart unit 20 when charging the battery 180.

The battery 180 may be coupled to a lower side of the cart unit 20. In some implementations, the battery 180 may be detachably coupled to an inner space of the main wheel support portion 213.

The battery 180 may be disposed at a position suitable for being electrically connected to the constituting elements. However, considering that the battery 180 generally has heavy weight, the battery 180 may be, preferably, provided at the lower side the cart unit 20 for stability of the cart unit 20.

The battery 180 is electrically connected to a voltage sensor 330. A voltage of the battery 180 may be sensed by the voltage sensor 330, so as to be transmitted to the controller 400.

### 2) Description of Wheel Part 200

The smart stroller 1 according to the implementations of the present disclosure includes the wheel part 200.

The wheel part 200 is provided at the cart unit 20 in a rotatable manner. As the wheel part 200 is rotated, the cart unit 20 may be rotated to the front, rear, left, or right side.

The wheel part 200 may be configured as any form that can be rotated and rolled. In some implementations, the wheel part 200 may be configured as wheels.

The wheel part 200 may be provided in plurality. In the depicted example, the wheel part 200 includes a main wheel 210 located on the rear side and a sub wheel 220 located on the front side.

That is, in the depicted example, the wheel part 200 includes the main wheel 210, the sub wheel 220, the motor 230, the brake 240, and the suspension 250.

The main wheel 210 is rotatably coupled to a lower rear side of the base portion 120. The main wheel 210 supports a rear side of the cart unit 20.

The main wheel 210 may be connected to the motor 230. The motor 230 may be rotated according to operation information input by the user, or operation information calculated according to a direction and strength (or magnitude) of force that the user pushes or pulls the handle 130. The motor 230 may be rotated according to a traveling condition or environment of the cart unit 20.

In detail, when the cart unit 20 travels uphill, the motor 230 may be operated so that the main wheel 210 is rotated in a direction toward the front side. When the cart unit 20 travels downhill, the motor 230 may be operated such that the main wheel 210 is rotated in a direction toward the rear side.

Accordingly, strength of force required for the user to make the cart unit 20 to travel or move may be reduced. Further, a safety incident or accident, due to arbitrary operation of the cart unit 20, may be prevented.

The main wheel 210 may be connected to or separated from the brake 240. As will be described later, the brake 240 may be operated (or activated) by operation information or when pressed by the user.

When the brake 240 is controlled to be operated, rotation of the main wheel 210 is inhibited. In some implementations, the brake 240 includes a pin inserted into a groove formed on an inner circumference of the main wheel 210, so as to inhibit rotation of the main wheel 210 in a manner of inserting the pin into the groove.

The main wheel 210 may be connected to the suspension 250. When there are irregularities on the ground (or road surface) on which the main wheel 210 is rotating and travelling, the suspension 250 is operated to absorb vertical shock or movement of the main wheel 210.

The main wheel 210 may be provided in plurality. In the depicted example, the main wheel 210 includes a first main wheel 211 located on the right side and a second main wheel 212 located on the left side.

The main wheel 210 may be constrained or locked by the brake 240. When the user presses the brake 240, rotation of the main wheel 210 may be inhibited. In some implementations, the brake 240 may be configured to be pressed with a foot, or operated by operation information.

The main wheel 210 includes the first main wheel 211, the second main wheel 212, and the main wheel support portion 213.

The first main wheel 211 and the second main wheel 212 are disposed to face each other by being spaced apart in a width direction of the base portion 120, namely, in the left-and-right direction in the illustrated example.

Rotation of any one of the first main wheel 211 and the second main wheel 212 may be inhibited by the brake 240. Accordingly, the cart unit 20 may be stopped when the user manipulates the brake 240.

In detail, grooves (not shown) may be respectively provided on surfaces of the first main wheel 211 and the second main wheel 212 that face each other That is, in the illustrated example, the grooves (not shown) may be respectively provided on a left surface of the first main wheel 211 and a right surface of the second main wheel 212 in a recessed manner.

The first main wheel 211 and the second main wheel 212 may be supported by the suspension 250. In some implementations, the first main wheel 211 and the second main wheel 212 may be elastically supported by the suspension 250.

Accordingly, although conditions of the ground (or road surface) with which the first main wheel 211 and the second main wheel 212 are in contact are different, the cart unit 20 and the baby seat unit 10 that is coupled to the cart unit 10 are not greatly shaken.

The first main wheel 211 and the second main wheel 212 are rotatably coupled to the main wheel support portion 213.

The main wheel support portion 213 rotatably supports the first main wheel 211 and the second main wheel 212. In addition, the main wheel support portion 213 is coupled to one side of the base portion 120 facing the ground, namely, to the lower rear side in the illustrated example.

The main wheel support portion 213 may be fixedly coupled to the base portion 120. Accordingly, even when the cart unit 20 travels in the left-and-right direction, a traveling direction of the main wheel 210 is not arbitrarily changed.

Therefore, the main wheel support portion 213 may be referred to as one constituting element of the base portion 120.

The main wheel support portion 213 extends in a direction toward the main wheels 211 and 212, namely, in the left-and-right direction in the illustrated example. The first main wheel 211 is rotatably coupled to a right end of the main wheel support portion 213. The second main wheel 212 is rotatably coupled to a left end of the main wheel support portion 213.

A space is formed inside the main wheel support portion 213. Some constituting elements of the brake 240 may be mounted to the space. In the space, the suspension 250 may be located adjacent to the main wheels 211 and 212.

In addition, the battery 180 that supplies power to each constituting element of the cart unit 20 may be provided inside the main wheel support portion 213.

The sub wheel 220 is rotatably coupled to a lower front side of the base portion 120. The sub wheel 220 supports a front side of the cart unit 20.

The sub wheel 220 may be provided in plurality. In the depicted example, the sub wheel 220 includes a first sub wheel 221 located on the right side and a second sub wheel 222 located on the left side.

The first sub wheel 221 and the second sub wheel 222 are disposed to be spaced apart from each other in the width direction of the base portion 120, namely, in the left-and-right direction in the illustrated example. A distance between the sub wheels 221 and 222 may be less than a distance between the main wheels 211 and 212.

The first sub wheel 221 and the second sub wheel 222 are rotatably coupled to the sub wheel support portion 223.

The sub wheel support portion 223 rotatably supports the sub wheel 220. In addition, the sub wheel support portion 223 is rotatably coupled to the base portion 120.

Accordingly, the sub wheel 220 may be rotated while being coupled to the sub wheel support portion 223. Also, as the sub wheel support portion 223 to which the sub wheel 220 is coupled is rotated relative to the base portion 120, a traveling direction of the sub wheel 220 may be changed.

That is, in the depicted example, the sub wheel 220 may be rotated with respect to a left-and-right direction of the sub wheel support portion 223. In addition, the sub wheel support portion 223 is coupled to the base portion 120 to be rotatable with respect to the up-and-down direction.

The sub wheel support portion 223 is coupled to one side of the base portion 120 opposite to the main wheel 210, namely, to the lower front side in the illustrated example. Accordingly, the sub wheel support portion 223 may be rotated relative to the base portion 120.

Thus, according to force applied by the user or a state in which the main wheel 210 is rotated, the sub wheel support portion 223 may be rotated to face a specific direction. This may allow the user to easily adjust a traveling direction of the cart unit 20.

The sub wheel support portion 223 may be made of a lightweight and high rigidity material. In some implementations, the sub wheel support portion 223 may be made of reinforced plastics.

In some implementations, the sub wheel support portion 223 may support the sub wheels 221 and 222 in the form of a bearing (not shown). Accordingly, the sub wheel support portion 223 is not rotated irrespective of rotation of the sub wheels 221 and 222.

The motor 230 is coupled to the main wheel 210 to allow the main wheel 210 to rotate. The motor 230 may rotate the main wheel 210 clockwise or counterclockwise. Accordingly, the main wheel 210 may be rotated in a direction that the cart unit 20 moves forward or backward.

The motor 230 may be provided in plurality. The plurality of motors 230 may be coupled to the main wheels 211 and 212, respectively. In the depicted example, the motor 230 includes a first motor 231 coupled to the first main wheel 211 and a second motor 232 coupled to the second main wheel 212.

The motor 230 is electrically connected to the pressure sensor 320. The motor 230 may be controlled to rotate or stop according to information sensed by the pressure sensor 320. The information is calculated by the controller 400. The motor 230 is electrically connected to the controller 400.

The motor 230 may be configured as any form that can be rotated and stopped according to power and operation information. In some implementations, the motor 230 may be configured as a motor member.

The brake 240 allows or inhibits rotation of the main wheel 210. The user may press the brake 240 to allow or inhibit rotation of the main wheel 210.

The brake 240 may be configured as any form that can allow or inhibit rotation of the main wheel 210. In some implementations, the brake 240 may be configured as a disk brake or a drum brake.

In some implantations, the brake 240 may be configured as a pin inserted into or extracted from the main wheel 210. For example, a plurality of grooves may be formed in the main wheel 210 to provide a space in which the brake 240 is inserted.

The brake 240 is located adjacent to the main wheel 210. In the depicted example, the brake 240 is provided on the main wheel support portion 213 at the rear side to be located adjacent to the first main wheel 211 at the right side. In this example, the brake 240 may allow or inhibit rotation of the first main wheel 211.

Alternatively, the brake 240 may be located adjacent to the second main wheel 212 at the left side. Here, the brake 240 may allow or inhibit rotation of the second main wheel 212.

The brake 240 may be operated when pressed by the user. Alternatively, the brake 240 may be operated according to operation information calculated by the controller 400. Here, the brake 240 may be electrically connected to the controller 400.

The suspension 250 absorbs vertical shock of the main wheel 210. The suspension 250 may elastically support the main wheel 210. In some implementations, the suspension 250 may be configured as an elastic member or a hydraulic cylinder.

The suspension 250 may be operated automatically or manually. That is, the suspension 250 may be automatically operated according to operation information calculated by the controller 400, or manually operated according to operation information input by the user. The suspension 250 may be electrically connected to the display 140 and the controller 400.

The suspension 250 may be located adjacent to the main wheels 211 and 212 in the inner space of the main wheel support portion 213. In this case, the suspension 250 may be provided in plurality.

A detailed process in which the motor 230, the brake 240, and the suspension 250 provided at the wheel part 200 are controlled by the controller 400 will be discussed later.

### 3. Description of Example Sensor Part 300

Referring back to FIGS. 5 to 9, the smart stroller 1 further includes the sensor part 300.

The sensor part 300 senses or detects information related to traveling of the cart unit 20. In addition, the sensor part 300 senses information related to air inside the seat space portion 12 of the baby seat unit 10 in which a baby is seated.

Information sensed by the sensor part 300 is transmitted to the controller 400, and the controller 400 calculates operation information for controlling the smart stroller 1 based on the received information. To this end, the sensor part 300 is electrically connected to the controller 400.

The sensor part 300 is electrically connected to the battery 180. The sensor part 300 may be powered by the battery 180.

The sensor part 300 is electrically connected to the display 140. Information sensed by the sensor part 300 may be output in the form of visual information through the display 140.

The sensor part 300 may sense information in real time and in a continuous manner. The information sensed by the sensor part 300 may be mapped to a sensed or detection time point so as to be transmitted to the controller 400.

In the depicted example, the sensor part 300 includes the touch sensor 310, the pressure sensor 320, the voltage sensor 330, the terrain sensor 340, the dust sensor 350, and the seat sensor 360.

The touch sensor 310 senses information regarding a distance between the handle 130 and an object. In addition, the touch sensor 310 detects whether an object is in contact with the handle 130. In some implementations, the object may be a user, or a hand or hands of the user.

The information sensed by the touch sensor 310 may be referred to as "contact information".

The touch sensor 310 is accommodated in the handle 130. In detail, the touch sensor 310 is accommodated in a space of the extended portion 132 that extends in one direction, namely, in the left-and-right direction in the drawings.

A fixing member may be provided to prevent the touch sensor 310 from being moved in the inner space of the extended portion 132.

As the touch sensor 310 is not exposed to the outside, it is not affected by an external environment. For example, even when it rains or snows, the touch sensor 310 may accurately sense contact information, and damage to the touch sensor 310, due to moisture or the like, may be prevented.

The touch sensor 310 extends in one direction. The touch sensor 310 may extend in the same direction as the extended portion 132. In the illustrated example, the touch sensor 310 extends in the left-and-right direction.

The touch sensor 310 may have a board shape with a predetermined thickness. In the depicted example, the touch sensor 310 has a rectangular board shape with a shorter side in the front-and-rear direction and a longer side in the left-and-right direction.

The touch sensor 310 may detect whether an object is located above or on (in contact with) one side of the handle 130. In the depicted example, the touch sensor 310 may detect whether an object is located above or in contact with an upper side of the handle 130.

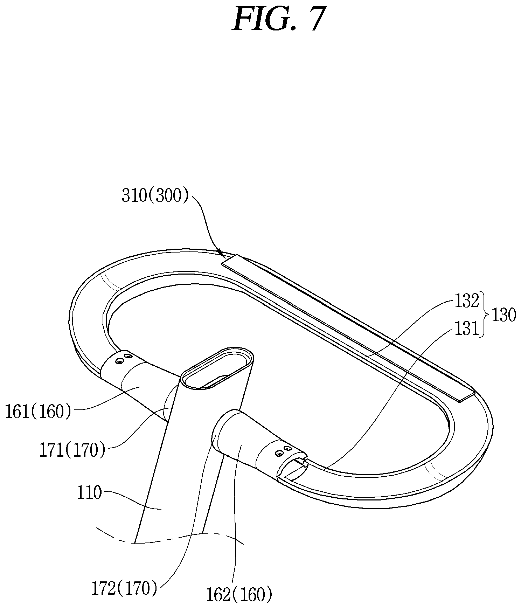

To this end, the touch sensor 310 may be disposed in a direction opposite to the base portion 120 in the inner space of the extended portion 132. That is, the touch sensor 310 may be located closer to the upper side (see FIG. 7).

The touch sensor 310 may sense contact information in real time and in a continuous manner. The contact information sensed by the touch sensor 310 may be mapped to a detection time point and transmitted to the controller 400.

The touch sensor 310 may detect whether an object exists at an outside of the handle 130 and whether the object is in contact with the handle 130. That is, the touch sensor 310 may transmit a signal passing through the handle 130, or receive a signal that has passed through the handle 130.

In some implementations, the touch sensor 310 may be configured as a high sensitivity sensor with high light transmission.

Accordingly, even when the user approaches the handle 130 and grips the handle 130 with gloves on, not with bare hands, this may be accurately sensed by the touch sensor 310.

In some implementations, the touch sensor 310 may be divided into a plurality of regions along its extension direction, namely along the left-and-right direction in the illustrated example. In this case, the touch sensor 310 may detect positions of the handle 130 gripped by the hands of the user in the up-and-down direction and the left-and-right direction. In addition, various types of contact information may be input according to a relative position between the hand (or hands) of the user and the handle 130.

The contact information sensed by the touch sensor 310 is transmitted to an information receiving module 410 of the controller 400. The touch sensor 310 and the information receiving module 410 are electrically connected to each other.

The pressure sensor 320 senses a direction and strength of force applied to the handle 130. That is, the pressure sensor 320 senses information regarding the direction and strength of force applied by the user for pushing or pulling the handle 130.

The information sensed by the pressure sensor 320 may be referred to as "pressure information".

The pressure sensor 320 may be configured as any form that can sense pressure information. In some implementations, the pressure sensor 320 may be configured as a loadcell sensor.

The pressure sensor 320 may be provided in plurality. The plurality of pressure sensors 320 may be disposed to face each other with the vertical portion 110 interposed therebetween. Alternatively, the plurality of pressure sensors 320 may be partially accommodated in the pressure sensor accommodating portions 161 and 162, respectively.

To this end, the pressure sensor 320 is electrically connected to the motor 230. The motor 230 may be rotated according to operation information calculated by the controller 400 using pressure information sensed by the pressure sensor 320.

In the depicted example, the pressure sensor 320 includes a first pressure sensor 321 located at the right side of the vertical portion 110 and a second pressure sensor 322 located at the left side of the vertical portion 110.

As the first pressure sensor 321 is located at the right side of the vertical portion 110, pressure information regarding force applied to a right side of the handle 130 by the user may be sensed.

The first pressure sensor 321 extends in one direction, namely, in the left-and-right direction in the illustrated example. The first pressure sensor 321 penetrates through an inside of the first pressure sensor accommodating portion 161 and an inside of the first manipulation portion 171.

One side (left end in the drawings) of the first pressure sensor 321 is coupled to the vertical portion 110. In some implementations, the one side of the first pressure sensor 321 may be fixedly coupled to the vertical portion 110.

Another side (right end in the drawings) of the first pressure sensor 321 is coupled to a bearing (not shown) accommodated in the handle 130. In some implementations, the another side of the first pressure sensor 321 may be fixedly coupled to the bearing (not shown).

That is, the another end of the first pressure sensor 321 extends up to the inner space of the connection portion 131 located at the right side of the handle 130.

Accordingly, even when the handle 130, the first pressure sensor accommodating portion 161, and the first manipulation portion 171 are rotated, the first pressure sensor 321 may be securely fixed to the vertical portion 110. Thus, an angular relationship between the first pressure sensor 321 and the vertical portion 110 may be constantly maintained.

The second pressure sensor 322 is located at the left side of the vertical portion 110 and senses pressure information regarding force applied to the left side of the handle 130 by the user.

The second pressure sensor 322 extends in one direction, namely, in the left-and-right direction in the illustrated example. The second pressure sensor 322 penetrates through an inside of the second pressure sensor accommodating portion 162 and an inside of the second manipulation portion 172.

One side (right end in the drawings) of the second pressure sensor 322 is coupled to the vertical portion 110. In some implementations, the one side of the second pressure sensor 322 may be fixedly coupled to the vertical portion 110.

Another side (left end in the drawings) of the second pressure sensor 322 is coupled to a bearing (not shown) accommodated in the handle 130. In some implementations, the another end of the second pressure sensor 322 may be fixedly coupled to the bearing (not shown).

That is, the another end of the second pressure sensor 322 extends up to the inner space of the connection portion 131 located at the left side of the handle 130.

Accordingly, even when the handle 130, the second pressure sensor accommodating portion 162, and the second manipulation portion 172 are rotated, the second pressure sensor 322 may be securely fixed to the vertical portion 110. Thus, an angular relationship between the second pressure sensor 322 and the vertical portion 110 may be constantly maintained.

As a result, even when the user rotates the handle 130 at various angles, the angular relationships between the first sensor 321 and the vertical portion 110, and between the second pressure sensor 322 and the vertical portion 110 may be constantly maintained.

This may allow the first and second pressure sensors 321 and 322 to accurately sense pressure information regarding force applied to the handle 130, regardless of rotation of the handle 130.

The voltage sensor 330 senses information regarding a voltage of the battery 180. The information sensed by the voltage sensor 330 is transmitted to the controller 400 and is used to calculate information regarding a remaining time available for operating the smart stroller 1. The voltage sensor 330 is electrically connected to the information receiving module 410.

The information sensed by the voltage sensor 330 may be referred to as "voltage information".

The voltage sensor 330 is electrically connected to the battery 180. A voltage of the battery 180 may be sensed by the voltage sensor 330.

The voltage sensor 330 may be disposed at a position suitable for being electrically connected to the battery 180. In some implementations, as in the case of the battery 180, the voltage sensor 330 may be accommodated in the inner space of the main wheel support portion 213 to be located adjacent to the battery 180.

The terrain sensor 340 senses information related to terrain of the surrounding environment in which the smart stroller 1 is traveling. The information sensed by the terrain sensor 340 is transmitted to the controller 400 and is used to calculate operation information for allowing the smart stroller 1 to travel in a stable manner. The terrain sensor 340 is electrically connected to the controller 400.

The information sensed by the terrain sensor 340 may be referred to as "terrain information". The terrain information may include information related to an inclination or tilt of the ground (or road surface), the presence and absence of irregularities such as a gravel and the like, and road conditions (e.g., a paved road).

The terrain sensor 340 is provided at the base portion 120 of the cart unit 20. In detail, the terrain sensor 340 is provided at one side of the base portion 120 opposite to the vertical portion 110, namely, in the front side in the illustrated example. In some implantations, the terrain sensor 340 may be provided at a front end of the base portion 120.

Accordingly, the terrain sensor 340 may sense terrain information regarding terrain ahead of the smart stroller 1, namely, the terrain to be travelled by the smart stroller 1, not the terrain passed by the smart stroller 1.

The terrain information sensed by the terrain sensor 340 is transmitted to the controller 400 through the information receiving module 410. The terrain sensor 340 is electrically connected to the controller 400.

The terrain sensor 340 may be configured as any form that can sense terrain information. In the depicted example, the terrain sensor 340 includes an infrared sensor 341 and a camera sensor 342.

The infrared sensor 341 senses terrain information regarding terrain ahead of the smart stroller 1 by using infrared rays. The infrared sensor 341 may be configured as any form that can irradiate or emit infrared rays forward and receive the emitted infrared rays again.

The infrared sensor 341 may sense information regarding the presence and absence of an obstacle and the like ahead of the smart stroller 1.

The camera sensor 342 senses terrain information regarding terrain ahead of the smart stroller 1 by using an image. The camera sensor 342 may be configured as any form that can receive visible light.

The terrain information sensed by the camera sensor 342 may be a still image or continuous still images.

The dust sensor 350 senses information regarding terrain of the surrounding environment in which the smart stroller 1 is traveling. The information sensed by the dust sensor 350 may be transmitted to the controller 400, so as to be used to calculate operation information for controlling the air cleaning module 13. The dust sensor 350 is electrically connected to the controller 400.

In addition, the information sensed by the dust sensor 350 may be output through the display 140, allowing the user to be informed. The dust sensor 350 is electrically connected to the display 140.

The information sensed by the dust sensor 350 may be referred to as "dust information". Dust information may include information related to the dust concentration (dust particle size).

The dust sensor 350 may be provided at the vertical portion 110. In detail, the dust sensor 350 is located at one side of the vertical portion 110 facing the baby seat unit 10, namely, the front side in the illustrated example.

The dust sensor 350 may be located adjacent to the upper end of the vertical portion 110. In detail, the dust sensor 350 may be located at the same height as the upper body or head of a baby seated in the seat space portion 12 of the baby seat unit 10 that is placed on the seat support portion 150.

Accordingly, the dust sensor 350 may sense dust information at the same position where air flows into the seat space portion 12. That is, the dust sensor 350 may sense dust information regarding air in the seat space portion 12 to be inhaled by the baby.

In other words, the dust sensor 350 is disposed to sense not only dust information regarding the environment in which the smart stroller 1 is traveling, but also dust information regarding air directly inhaled by the baby.

Accordingly, the user may take quick and appropriate action, such as using the air cover 30 and operating the air cleaning module 13, by recognizing or checking dust information regarding air to be inhaled by the baby.

The seat sensor 360 senses information regarding a state (or condition) the seat space portion 12 of the baby seat unit 10 in which a baby is seated. The information sensed by the seat sensor 360 is transmitted to the controller 400 and is used to calculate operation information for operating the air cleaning module 13.

In addition, the information sensed by the seat sensor 360 is informed or notified to the user, so that the user can take necessary action such as removing the air cover 30 or moving the baby to an outside of the seat space portion 12.

The information sensed by the seat sensor 360 may be referred to as "seat information". The seat information may include temperature information regarding an internal temperature, humidity information regarding humidity, and air information regarding air quality of the seat space portion 12.

The seat sensor 360 may be provided inside the seat space portion 12. The seat sensor 360 may be provided at the mounting portion located at the lower side of the seat space portion 12 or the seat body portion 11 that surrounds the seat space portion 12.

Alternatively, the seat sensor 360 may sense a body temperature, humidity, and the like of a baby in a direct contact manner. In this case, the seat sensor 360 may be, preferably, configured as a textile sensor so that a baby does not feel uncomfortable due to the seat sensor 360.

In the illustrated example, the seat sensor 360 includes a temperature sensor 361, a humidity sensor 362, and an air sensor 363.

The temperature sensor 361 senses temperature information regarding an internal temperature of the seat space portion 12. In some implementations, the temperature sensor 361 may sense a body temperature of a baby, as described above.

The humidity sensor 362 senses humidity information regarding humidity inside the seat space portion 12. In some implementations, the humidity sensor 362 may sense humidity of the baby, for example, sweating, a bowel movement, and the like.

The air sensor 363 senses air information regarding air quality inside the seat space portion 12. The air information may be information related to the concentration of dust or fine dust in the seat space portion 12. In addition, the air information may be information related to the concentration of carbon dioxide in the seat space portion 12.

Information sensed by the seat sensor 360 may be output through the display 140. The seat sensor 360 is electrically connected to the display 140.

Through this displayed information, the user may take various actions to improve the environment in the seat space portion 12.

For example, when the sensed temperature information is considered to be very high, the user may take action such as removing the air cover 30.

When the sensed humidity information is considered to be very high, the user may take action such as checking a bowel movement of the baby.

When the sensed air information is considered to be unhealthy for the baby, the user may take action such as operating the air cleaning module 13.

Besides the action taken by the user, the controller 400 to which the sensed air information is transmitted may calculate operation information for operating the air cleaning module 13, so as to control the air cleaning module 13 to be operated.

### 4. Description of Example Controller 400

Referring back to FIGS. 5 to 9, the smart stroller 1 further includes the controller 400.

The controller 400 is electrically connected to the sensor part 300, so as to receive information sensed by the sensor part 300. The controller 400 calculates operation information for controlling various constituting elements provided in the smart stroller 1 using the received information.

The controller 400 is electrically connected to various constituting elements provided in the smart stroller 1. In some implementations, the controller 400 may be electrically connected to the air cleaning module 13, the display 140, the manipulation portion 170, the battery 180, the motor 230, the brake 240, the suspension 250, and the like.

Operation information input by the user through the display 140 or the manipulation portion 170 may be transmitted to the controller 400. In addition, the controller 400 may control the air cleaning module 13, the battery 180, the motor 230, the brake 240, the suspension 250, and the like according to calculated operation information. Further, the controller 400 may transmit sensed information or calculated operation information to the display 140.

The controller 400 may be configured as any form that can input, calculate, and output information. In some implementations, the controller 400 may be configured as a microprocessor, CPU, or the like.

Although not illustrated in the drawings, the controller 400 may transmit received information and calculated operation information to an external terminal (not shown). In some implementations, the terminal (not shown) may be configured as a smartphone, a smart pad, or the like.

In this case, the controller 400 may be electrically connected to the terminal (not shown) in a wireless or wired manner. In some implementations, the electrical connection may be archived in a Bluetooth or Wi-Fi manner.

Modules 410, 420, 430, 440, 450, 460, 470, and 480 of the controller 400, which will be described hereinafter, are electrically connected to each other. The modules 410, 420, 430, 440, 450, 460, 470, and 480 may transmit or receive information to and receive from one another.

In the depicted example, the controller 400 includes the information receiving module 410, a touch information calculation module 420, a traveling information calculation module 430, an environment information calculation module 440, an internal information calculation module 450, an operation information calculation module 460, the control module 470, and an information output module 480.

The information receiving module 410 receives information sensed by the sensor part 300. The information receiving module 410 is electrically connected to the sensor part 300. This electrical connection may be achieved in a wireless or wired manner.

In detail, the information receiving module 410 receives contact information sensed by the touch sensor 310, pressure information sensed by the pressure sensor 320, voltage information sensed by the voltage sensor 330, and terrain information sensed by the terrain sensor 340, dust information sensed by the dust sensor 350, and seat information sensed by the seat sensor 360.

The information received by the information receiving module 410 is transmitted to the information calculation modules 420, 430, 440, and 450.

In detail, contact information is transmitted to the touch information operation module 420. Pressure information and voltage information are transferred to the operation information calculation module 430. Terrain information and dust information are transmitted to the environment information calculation module 440, and seat information is transferred to the internal information calculation module 450.

In addition, the information received by the information receiving module 410 may be output to the display 140 through the information output module 480.

The touch information calculation module 420 calculates touch information by using sensed contact information. The touch information may include information regarding a relative position between the handle 130 and an object such as a hand or hands of the user (hereinafter referred to as "object"), and information regarding whether or not the object is in contact with the handle 130 and a contact position (or location).

The touch information calculation module 420 calculates touch information by comparing the sensed contact information with preset reference contact information.

The reference contact information may be reference information for determining that the handle 130 is gripped by the hand or hands of the user. In some implementations, the reference contact information may be information indicating that one or two points (or portions) of the handle 130 are touched by an object.

That is, the reference contact information may be a case in which the user is gripping the handle 130 with one or both hands.

When the sensed contact information corresponds to the reference contact information, the touch information calculation module 420 calculates touch information indicating that the handle 130 is gripped by the hand or hands of the user.

In addition, when the sensed contact information does not correspond to the reference contact information, the touch information calculation module 420 calculates touch information indicating that the handle 130 is not gripped by the hand or hands of the user. This may be a case in which the user is leaning against the handle 130, or several users are holding the handle 130.

The calculated touch information is transmitted to the operation information calculation module 460. The touch information calculation module 420 and the operation information calculation module 460 are electrically connected to each other.

The traveling information calculation module 430 calculates traveling information by comparing sensed pressure information with preset reference pressure information.

The reference pressure information may be reference information for determining that the user is gripping the handle 13 with one or both hands to apply force to the smart stroller 1. In some implementations, the reference pressure information may be information indicating that force is applied to the handle 130 in the front-and-back direction, the left-and-right direction, and a combined direction thereof.

When the sensed pressure information corresponds to the reference pressure information, the traveling information calculation module 430 calculates traveling information indicating that the handle 130 is being pressed in a specific direction by the user. That is, the calculated traveling information includes information regarding whether or not the handle 130 is pressed, and regarding a direction and strength of force applied to the handle 130.

In addition, the traveling information calculation module 430 calculates traveling information by comparing sensed voltage information with preset reference voltage information.

The reference voltage information may be information to which a remaining traveling time for the smart stroller 1 based on voltage information of the battery 180 is mapped.

In detail, as the smart stroller 1 is operated, the battery 180 is discharged and the voltage is reduced accordingly. Therefore, a remaining time available for the smart stroller 1 to travel is determined according to the voltage information of the battery 180.

Thus, the traveling information calculation module 430 may calculate traveling information by comparing the sensed voltage information with the reference voltage information.

In some implementations, the reference voltage information may be information regarding the maximum battery consumption of the battery 181 when all the constituting elements of the smart stroller 1 are operated.

The calculated traveling information may be output in the form of a remaining distance or time available for the smart stroller 1 to travel. Since it is difficult for the user to accurately recognize the traveling distance, the calculated traveling information may be, preferably, output as the remaining time.

The calculated traveling information is transmitted to the operation information calculation module 460. The traveling information calculation module 430 and the operation information calculation module 460 are electrically connected to each other.

Further, the calculated traveling information may be transmitted to the display 140 through the information output module 480, so as to be output in the form of visual information. The traveling information calculation module 430 is electrically connected to the information output module 480 and the display 140.

The environment information calculation module 440 compares sensed terrain information with preset reference terrain information to calculate environment information regarding a surrounding environment in which the smart stroller 1 is traveling.

The reference terrain information may be information regarding terrain at one side of the smart stroller 1, for example, information regarding terrain at the front.

For instance, the reference terrain information may include information regarding a traveling environment ahead of the smart stroller 1, namely, whether it is an uphill, flat, or downhill road.

In addition, the reference terrain information may include information regarding the presence and absence of an obstacle and the like on the ground surface ahead, the presence and absence of irregularities on the ground surface (e.g., bumpy road), and whether it is a paved or unpaved road.

As described above, the terrain sensor 340 that senses terrain information may be provided with the infrared sensor 341 and the camera sensor 342. Accordingly, the reference terrain information may include both terrain information sensed by the infrared sensor 341 and terrain information sensed by the camera sensor 342.

Accordingly, compared to a case in which terrain information is sensed by a single sensor, accuracy of sensed terrain information and environment information calculated based on it may be increased.

In addition, the environment information calculation module 440 compares sensed dust information with preset reference dust information to calculate environment information regarding the surrounding environment in which the smart stroller 1 is traveling.

In the reference dust information, air quality according to the concentration of dust or fine dust is mapped. In some implementations, the reference dust information may be expressed as "Good", "Moderate", and "Bad", for example.

Accordingly, the environment information calculation module 440 may calculate environment information by comparing the sensed dust information with the reference dust information.

As described above, the dust sensor 350 is located adjacent to a height of a position where air inhaled by a baby is introduced into the seat space portion 12. Accordingly, it will be understood that the sensed dust information and the environment information calculated based on it are environment information regarding air to be inhaled by the baby, among the surrounding environments of the smart stroller 1.

Therefore, the calculated environment information may reflect quality or (condition) of air to be inhaled by the baby more accurately.

The calculated environment information is transmitted to the operation information calculation module 460. The environment information calculation module 440 and the operation information calculation module 460 are electrically connected to each other.

In addition, the calculated environment information may be transmitted to the display 140 through the information output module 480, so as to be output in the form of visual information. The environment information calculation module 440 is electrically connected to the information output module 480 and the display 140.

Accordingly, information regarding terrain ahead of the smart stroller 1 and information regarding quality of air to be inhaled by the baby may be output to the display 140.

The internal information calculation module 450 compares sensed seat information with preset reference seat information to calculate internal information regarding a state of the seat space portion 12 in which the baby is seated.

The reference seat information may be information related to pleasantness and comfort of the baby seated in the seat space portion 12.

As described above, the seat information includes temperature, humidity, and air information. Accordingly, the reference seat information also includes reference temperature information, reference humidity information, and reference air information.

In the reference seat information, the state or condition of the baby according to a temperature, humidity, or air quality is mapped.

For example, the reference temperature information may be information classified as "Good", "Moderate", and "Bad" according to high and low temperature levels. Also, the reference humidity information may be information classified as "Good", "Moderate", and "Bad" according to high and low humidity levels. Likewise, the reference air information may be information classified as "Good", "Moderate", and "Bad" according to dust concentration levels.

Accordingly, the internal information calculation module 450 calculates internal information by comparing sensed seat information, namely, the sensed temperature information, humidity information and air information with the reference temperature information, the reference humidity information, and the reference air information, respectively.

The calculated internal information is transmitted to the operation information calculation module 460. The internal information calculation module 450 is electrically connected to the operation information calculation module 460.

In addition, the calculated internal information may be transmitted to the display 140 through the information output module 480, so as to be output in the form of visual information. The internal information calculation module 440 is electrically connected to the information output module 480 and the display 140.

The operation information calculation module 460 calculates operation information for controlling operation of the constituting elements of the smart controller 1 by using calculated touch information, traveling information, environment information, and internal information.

The calculated operation information is transmitted to the control module 470. The operation information calculation module 460 and the control module 470 are electrically connected to each other.

The operation information calculation module 460 calculates operation information for controlling the brake 240 by using calculated touch information.

In detail, when the calculated touch information indicates that the handle 130 is gripped by the hand or hands of the user, the operation information calculation module 460 calculates operation information for controlling the brake 240 to be released.

That is, when the handle 130 is gripped by the user, it may be determined that the user is intended to use the smart stroller 1. Accordingly, the operation information calculation module 460 calculates operation information for controlling the brake 240 to be released so as to allow the main wheels 211 and 212 to rotate.

In contrast, when the calculated touch information indicates that the handle 130 is not gripped by the hand or hands of the user, the operation information calculation module 460 calculates operation information for controlling the brake 240 to be operated.

That is, when the hands of the user are apart from the handle 130, it may be determined that the user is intended to stop the smart stroller 1. Accordingly, the operation information calculation module 460 calculates operation information for controlling the brake 240 to be operated so as to inhibit the main wheels 211 and 212 from rotating.

The operation information calculation module 460 calculates operation information for controlling the motor 230 by using calculated traveling information.

In detail, when the calculated traveling information indicates that force is applied to the handle 130 in a specific direction with predetermined strength, the operation information calculation module 460 calculates operation information for controlling a rotation direction of the motor 230 so that the main wheels 211 and 212 are rotated to be moved to the specific direction.

In addition, the operation information calculation module 460 calculates operation information for controlling a rotational speed of the motor 230 so that the smart stroller 1 travels at a predetermined speed or less by using strength of the force applied to the handle 130.

Here, the predetermined speed may be defined as a maximum speed that can ensure safety of the baby in the smart stroller 1.

In addition, the operation information calculation module 460 calculates operation information for controlling the battery 180 by using calculated traveling information.

In detail, when the calculated traveling information indicates that the reaming or residual voltage of the battery 180 is sufficient, the operation information calculation module 460 calculates operation information for allowing constituting elements of the smart stroller 1, such as the air cleaning module 13, the motor 230, the brake 240, and the suspension 250, to be operated at maximum performance.

In contrast, when the calculated traveling information indicates that the residual voltage of the battery 180 is insufficient, the operation information calculation module 460 calculates operation information for allowing constituting elements of the smart stroller 1, such as the air cleaning module 13, the motor 230, the brake 240, and the suspension 250, to be operated at minimum performance.

The operation information calculation module 460 calculates operation information for controlling the motor 230 using calculated environment information.

In detail, when the calculated environment information includes an uphill road in a traveling direction of the smart stroller 1, the operation information calculation module 460 calculates operation information for controlling a rotation direction of the motor 230 so that the main wheels 211 and 212 are rotated to move toward the traveling direction.

When the calculated environment information includes a downhill road in a traveling direction of the smart stroller 1, the operation information calculation module 460 calculates operation information for controlling a rotation direction of the motor 230 so that the main wheels 211 and 212 are rotated to move toward a direction opposite to the traveling direction.

In addition, when the calculated environment information includes irregularities on a road surface in a traveling direction of the smart stroller 1, the operation information calculation module 460 calculates operation information for controlling the motor 230 to rotate at a low speed.

The operation information calculation module 460 calculates operation information for controlling the suspension 250 by using the calculated environment information.

In detail, when the calculated environment information indicates that there are a large number of irregularities on the road surface in a traveling direction of the smart stroller 1, the operation information calculation module 460 calculates operation information for increasing a damping force of the suspension 250.

When the calculated environment information indicates that there are no or a small number of irregularities on the road surface in a traveling direction of the smart stroller 1, the operation information calculation module 460 calculate operation information for reducing a damping force of the suspension 250.

The operation information calculation module 460 calculates operation information for controlling the air cleaning module 13 by using calculated environment information and internal information.

In detail, when the calculated environment information and internal information indicates high concentration of fine dust, the operation information calculation module 460 calculates operation information for controlling the air cleaning module 13 to purify more amount of air.

In addition, when the calculated environment information and internal information indicates low concentration of fine dust, the operation information calculation module 460 calculates operation information for controlling the air cleaning module 13 to purify less amount of air.

The operation information calculated by the operation information calculation module 460 is transmitted to the control module 470. The operation information calculation module 460 is electrically connected to the control module 470.

In addition, each operation information calculated by the operation information calculation module 460 is transmitted to the information output module 480, so as to be output in a user-recognizable manner. The operation information calculation module 460 is electrically connected to the information output module 480.

The control module 470 controls each constituting element of the smart stroller 1 according to the calculated operation information.

In the depicted example, the control module 470 includes a brake control unit 471, a motor control unit 472, a suspension control unit 473, and an air cleaning control unit 474.

According to the calculated operation information, the brake control unit 471 controls the brake 240 to be operated so as to inhibit the main wheels 211 and 212 from rotating, or to be released so as to allow the main wheels 211 and 212 to rotate. The brake control unit 471 is electrically connected to the brake 240.

The motor control unit 472 controls rotation, a rotation direction, and a rotational speed of the motor 230 according to the calculated operation information. As described above, the motor 230 includes the first motor 231 and the second motor 232.

The motor control unit 472 may independently control the first motor 231 and the second motor 232. The motor control unit 472 is electrically connected to the motor 230.

The suspension control unit 473 controls the suspension 250 to increase or decrease a damping force of the suspension 250 according to the calculated operation information. The suspension control unit 473 is electrically connected to the suspension 250.

The air cleaning control unit 474 controls operation and an operation speed of the air cleaning module 13 according to the calculated operation information. The air cleaning control unit 474 is electrically connected to the air cleaning module 13.

In some implementations, the control module 470 may be electrically connected to the battery 180, so as to control operation of the battery 180. That is, when traveling information includes information regarding a voltage of the battery 180, the control module 470 may control the operation of the battery 180.

The information output module 480 calculates the calculated operation information as a user-recognizable manner to output. In some implementations, the information output module 480 may calculate the calculated operation information in the form of visual information.

The information calculated by the information output module 480 may be output through the display 140. The information output module 480 is electrically connected to the display 140.

In an example in which a light-emitting unit such as an LED lamp is provided in the air cleaning module 13, information calculated by the information output module 480 may be output through the air cleaning module 13. The information output module 480 is electrically connected to the air cleaning module 13.

### 5. Description of Example Method of Controlling Smart Stroller 1

A method of controlling the smart stroller 1 according to implementations of the present disclosure may be controlled through the above-described configurations. Accordingly, the user can easily recognize information related to traveling of the smart stroller 1. In addition, the smart stroller 1 may be automatically controlled using information regarding traveling, which allows the user to easily use the smart stroller 1.

Further, safety and comfort of the baby in the smart stroller 1 may be improved.

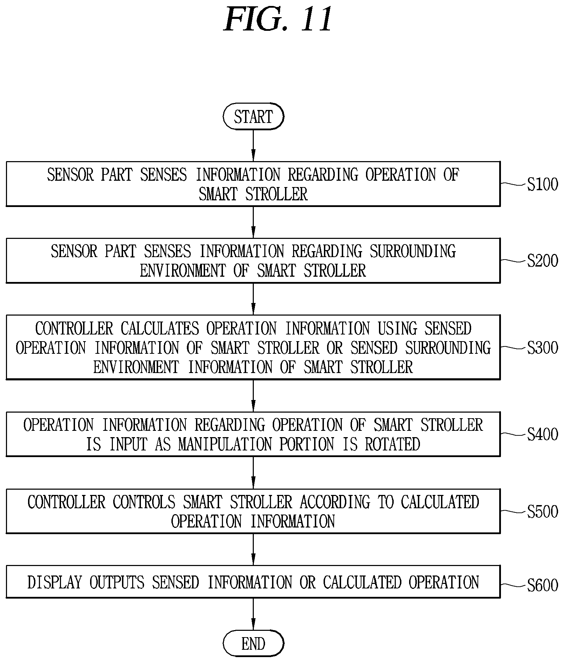

Hereinafter, the method of controlling the smart controller 1 will be described in detail with reference to FIGS. 11 to 17.

In the depicted example, the method of controlling the smart stroller 1 includes the steps of sensing, by the sensor part 300, information regarding operation of the smart stroller 1 (S100), sensing, by the sensor part 300, information regarding the surrounding environment (S200), calculating, by the controller 400, operation information using the sensed information regarding operation of the smart stroller 1 or the sensed information regarding the surrounding environment of the smart stroller 1 (S300), receiving, by the manipulation portion 170, information regarding operation of the smart stroller 1 when being rotated (S400), controlling, by the controller 400, the smart stroller 1 according to the calculated operation information (S500), and outputting, by the display 140, the sensed information or the calculated operation information (S600).

### (1) Description of Step S100: Sensing, by the sensor part 300, information regarding operation of the smart stroller 1

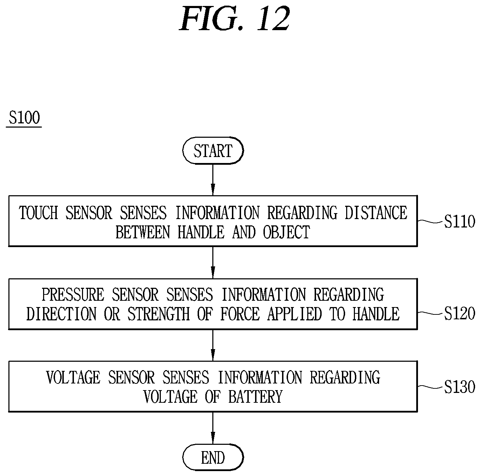

The step S100 is a step in which the touch sensor 310, the pressure sensor 310, and the voltage sensor 330 of the sensor part 300 sense an operation state of the smart stroller 1. Hereinafter, the step S100 will be described in detail with reference to FIG. 12.

The touch sensor 310 senses contact information, which is information regarding a distance between the handle 130 and an object (S110). As described above, the object may be a hand or hands of a user.

The contact information sensed by the touch sensor 310 may include information regarding the distance between the handle 130 and the object, information regarding whether or not the object is in contact with the handle 130, and the number of contact points or regions.

The contact information sensed by the touch sensor 310 is transmitted to the contact information calculation module 420.

In addition, the pressure sensor 320 senses pressure information regarding a direction or strength of force applied to the handle 130 (S120). The pressure information sensed by the pressure sensor 320 may include information regarding both the direction and the strength of force.

The pressure information sensed by the pressure sensor 320 is transmitted to the traveling information calculation module 430.

In addition, the voltage sensor 330 senses voltage information regarding a voltage of the battery 180 (S130).

The voltage information sensed by the voltage sensor 330 is transmitted to the traveling information calculation module 430.

### (2) Description of Step S200: Sensing, by the sensor part 300, information regarding the surrounding environment of the smart stroller 1

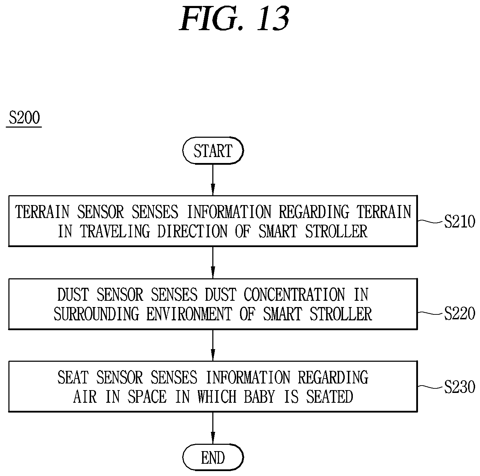

The step of S200 is a step in which the terrain sensor 340, the dust sensor 350, and the seat sensor 360 of the sensor part 300 provided in the smart stroller 1 sense information regarding the surrounding environment of the smart stroller 1. Hereinafter, the step S200 will be described in detail with reference to FIG. 13.

The terrain sensor 340 senses information regarding terrain in a proceeding (or traveling) direction of the smart stroller 1 (S210). That is, the terrain sensor 340 senses the terrain in the proceeding direction of the smart stroller 1.

As described above, the terrain sensor 340 includes the infrared sensor 341 and the camera sensor 342. Accordingly, the terrain sensor 340 may sense at least two types of terrain information.

The terrain information sensed by the terrain sensor 340 is transmitted to the traveling information calculation module 430.

The dust sensor 350 senses information regarding dust concentration in the surrounding environment of the smart stroller 1 (S220). That is, the dust sensor 350 senses dust in an area where the smart stroller 1 is located.

As described above, the dust sensor 350 may be located adjacent to an upper end of a front surface of the vertical portion 110. Accordingly, the dust sensor 350 may sense dust information of air to be introduced into the seat space portion 12 of the baby seat unit 10.

The dust information sensed by the dust sensor 350 is transmitted to the environment information calculation module 440.

The seat sensor 360 senses information regarding air in the seat space portion 12 in which a baby is seated (S230). That is, the seat sensor 360 senses air information regarding air quality in the seat space portion 12.

As described above, the seat sensor 360 may include the temperature sensor 361, the humidity sensor 362, and the air sensor 363. Accordingly, the seat sensor 360 may also sense information regarding a temperature and humidity in the seat space portion 12.

The seat information sensed by the seat sensor 360, namely, temperature information, humidity information, and air information are transmitted to the internal information calculation module 450.

### (3) Description of Step S300: Calculating, by the controller 400, operation information by using information regarding operation of the smart stroller 1 or information regarding the surrounding environment of the smart stroller 1

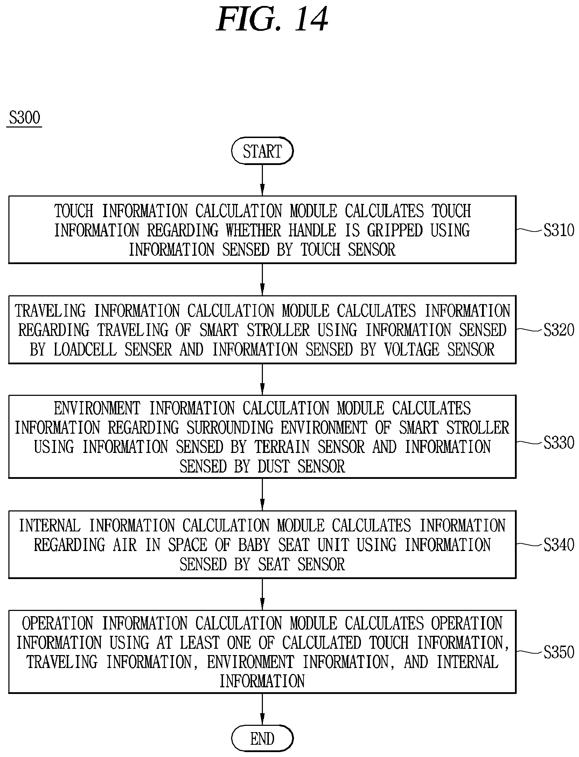

The step S300 is a step in which the information calculation modules 420, 430, 440, and 450 of the controller 400 calculate touch information, traveling information, environment information, and internal information by using the sensed contact information, pressure information, voltage information, terrain information, dust information, and seat information. Hereinafter, the step S30 will be described in detail with reference to FIG 14.

The touch information calculation module 420 calculates touch information, which is information regarding whether the handle 130 is gripped by the user using the sensed contact information (S310). In some implementations, the touch information may include information regarding a distance or a relative position between the handle 130 and the hand or hands of the user, as described above.

The touch information calculated by the touch information calculation module 420 is transmitted to the operation information calculation module 460.

The traveling information calculation module 430 calculates traveling information, which is information regarding traveling of the smart stroller 1 by using the sensed pressure information and voltage information (S320). That is, the traveling information includes information regarding whether pressure is applied to the smart stroller 1 by the user, or information regarding a remaining time or distance available for the smart stroller 1 to travel by using the residual voltage of the battery 180.

The traveling information calculated by the traveling information calculation module 430 is transmitted to the operation information calculation module 460.

The environment information calculation module 440 calculates environment information, which is information regarding the surrounding environment of the smart stroller 1 by using the sensed terrain information and dust information (S330). That is, the environment information includes information regarding terrain of the area to be travelled by the smart stroller 1 and information regarding dust concentration of the air to be inhaled by the baby.

The environment information calculated by the environment information calculation module 440 is transmitted to the operation information calculation module 460.

The internal information calculation module 450 calculates internal information, which is information regarding the seat space portion 12 of the baby seat unit 10 using the sensed seat information (S340). That is, the internal information includes information regarding a temperature, humidity, and air quality of the seat space portion 12.

The environment information calculated by the internal information calculation module 450 is transmitted to the operation information calculation module 460.

The operation information calculation module 460 calculates operation information using one or more of the calculated touch information, traveling information, environment information, and internal information (S350).

In detail, the operation information calculation module 460 calculates operation information for controlling the air cleaning module 13, the motor 230, the brake 240, and the suspension 250 using the calculated information.

The operation information operation module 460 calculates operation information using the calculated information as described above.

The operation information calculated by the operation information calculation module 460 is transmitted to the control module 470.

### (4) Description of Step S400: Receiving operation information regarding operation of the smart stroller 1 by the manipulation portion 170 when being rotated

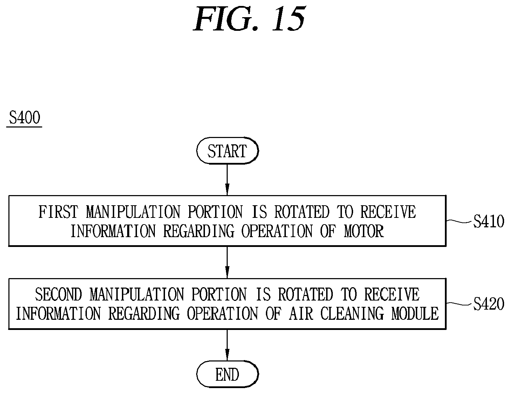

The manipulation portion 170 receives operation information regarding operation of the smart stroller 1 when being rotated by the user (S400). Hereinafter, the step S400 will be described in detail with reference to FIG. 15.

The first manipulation portion 171 receives operation information regarding operation of the motor 230 when being rotated by the user (S410). The operation information, which is input through the first manipulation portion 171, is transmitted to the motor control unit 472 of the control module 470.

The second manipulation portion 172 receives operation information regarding operation of the air cleaning module 13 when being rotated by the user (S420). The operation information, which is input through the second manipulation portion 172, is transmitted to the air cleaning control unit 474 of the control module 470.

### (5) Description of Step S500: Controlling, by the controller 400, the smart stroller 1 according to the calculated operation information

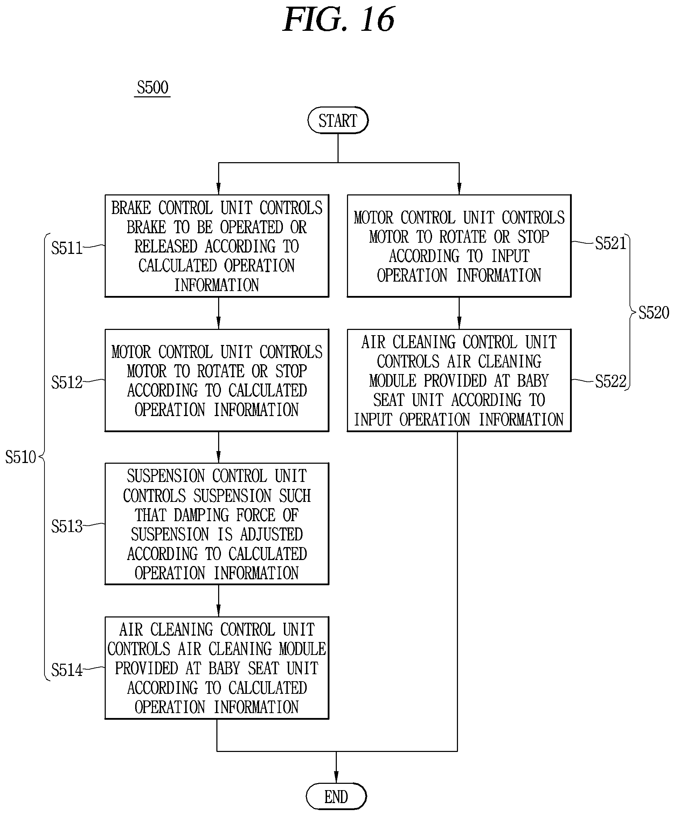

The step S500 is a step in which the control module 470 of the controller 400 controls each constituting element of the smart stroller 1 according to the calculated operation information or input operation information (S500). Hereinafter, the step S500 will be described in detail with reference to FIG 16.

This step may be divided into a step S510 in which the control module 470 controls each constituting element of the smart stroller 1 according to the calculated operation information (S510) and a step S520 in which the control module 470 controls each constituting element of the smart stroller 1 according to the input operation information.

First, the step S510 in which the control module 470 controls each constituting element of the smart stroller 1 according to the calculated operation information will be described.

The brake control unit 471 controls the brake 240 to be operated or released according to the operation information calculated by the operation information calculation module 460 (S511). That is, the brake control unit 471 controls the brake 240 so that rotation of the main wheels 211 and 212 are allowed or inhibited corresponding to the calculated operation information.

The motor control unit 472 controls the motor 230 to rotate or stop according to the operation information calculated by the operation information calculation module 460 (S512). That is, the motor control unit 472 controls such that the motor 230 rotates in a direction and at speed corresponding to the calculated operation information, or stops.

The suspension control unit 473 controls the suspension 250 such that a damping force of the suspension 250 is adjusted according to the operation information calculated by the operation information calculation module 460 (S513). That is, the suspension control unit 473 controls the suspension 250 to increase, maintain, or decrease the damping force of the suspension 250 according to the calculated operation information.

The air cleaning control unit 474 controls the air cleaning module 13 to operate according to the operation information calculated by the operation information calculating module 460 (S514). That is, the air cleaning control unit 474 controls the air cleaning module 13 such that an amount of air to be purified is adjusted according to the calculated operation information.

Next, the step S520 in which the control module 470 controls the constituting elements of the smart stroller 1 according to the input operation information will be described.

The motor control unit 472 controls the motor 230 to rotate or stop according to the operation information which is input when the manipulation portion 171 is rotated (S521). That is, the motor control unit 472 controls the motor 230 such that the motor 230 rotates in a direction and at speed corresponding to the input operation information, or stops.

The air cleaning control unit 474 controls the air cleaning module 13 to operate according to the operation information which is input when the second manipulation portion 172 is rotated (S522). That is, the air cleaning control unit 474 controls the air cleaning module 13 such that the amount air to be purified is adjusted according to the input operation information.

### (6) Description of Step S600: Outputting, by the display140, the sensed information or the calculated operation information

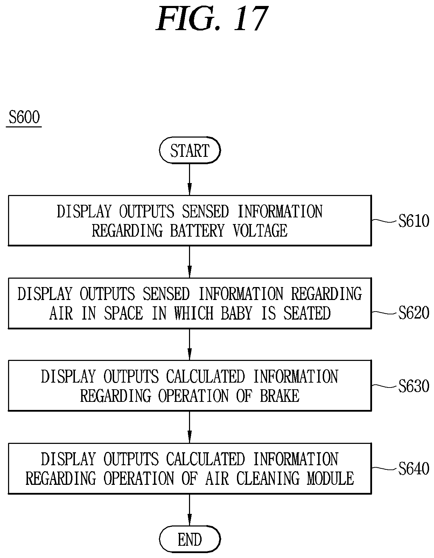

The step S600 is a step in which the display 140 outputs information sensed by the sensor part 300 or operation information calculated by the controller 400, so as to be recognized by the user (S600). Hereinafter, the step S600 will be described in detail with reference to FIG 17.

The display 140 outputs voltage information regarding a voltage of the battery 180, among the sensed information (S610). In some implementations, the voltage information may be output as a remaining distance or a remaining time available for the smart stroller 1 to travel.

The display 140 outputs air information regarding air in the seat space portion 12 in which the baby is seated, among the sensed information (S620). In some implementations, the air information may be output as dust concentration or carbon dioxide concentration in the seat space portion 12.

In some implementations, the display 140 may output dust information sensed by the dust sensor 350.

The display 140 outputs operation information regarding whether the brake 240 is operated, among the calculated operation information (S630). In some implementations, the operation information may be output in the form of information indicating operation or release of the brake 240.

The display 140 outputs operation information regarding operation of the air cleaning module 13, among the calculated operation information (S640). In some implementations, the operation information may be output in the form of a volumetric flow rate per hour at which the air cleaning module 13 purifies air, or in the form of an operation status of the air cleaning module 13, namely automatic or manual operation.

### 6. Description of Example of Information Output to Display 140 when Smart Stroller 1 is Operated

The smart stroller 1 of the present disclosure may be operated according to the above-described configuration and control method, so as to calculate various information and be operated according to the calculated information. In addition, the sensed information and the calculated operation information are output through the display 140, allowing the user to recognize them.

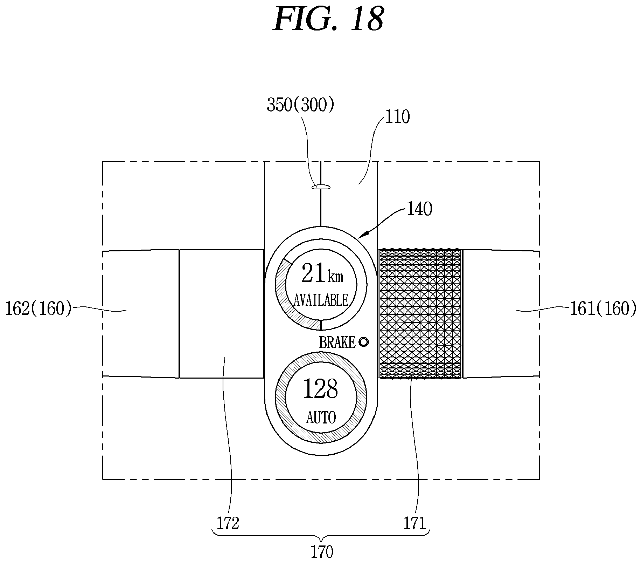

Hereinafter, an example of outputting sensed and calculated information to the display 140 will be described in detail with reference to FIG. 18.

FIG. 18 illustrates an example in which sensed information and calculated operation information are output to the display 140.

First, referring to an upper circle in the drawing, "21 km available" is displayed inside the circle. The displayed text indicates sensed voltage information or traveling information calculated using the sensed voltage information.

As described above, the sensed voltage information or the calculated traveling information may be expressed as a remaining time during which the smart stroller 1 can travel.

In an outer circumference of the upper circle, a shape of ring in which a part (i.e., the left side in the drawing) thereof is lit. The shape indicates the sensed voltage information, which is a ratio of the residual voltage to the total voltage when the maximum voltage of the battery 180 is the entire circumference of the ring.

Between the upper circle and a lower circle, "break" and a light-off circle are displayed. The displayed text and the circle indicate that the brake 240 is in a released state, that is, a state that the main wheels 211 and 212 can rotate.

Referring to the lower circle, "128" is displayed inside the circle. The displayed number indicates the fine dust concentration, which is air information sensed by the air sensor 363. Alternatively, the displayed number may indicate the fine dust concentration, which is dust information sensed by the dust sensor 350.

"Automatic" is displayed below the number. The text indicates that the air cleaning module 13 is being automatically operated, that is, the air cleaning module 13 is operated according to calculated operation information.

In an outer circumference of the lower circle, a shape of ring in which the entire part thereof is lit. The shape indicates the sensed air information or dust information, and various types of information may be output by changing a color of the light.

For example, the color may be expressed as green for "Good", yellow for "Moderate", orange for "Bad (Unhealthy)", and red for "Very bad (Very unhealthy)". The sensed fine dust concentration is 128, which corresponds to "Bad", and thus the ring may be lit in orange.

The foregoing description has been given of the preferred implementations, but it will be apparent to those skilled in the art that various modifications and variations can be made in the present disclosure without departing from the spirit or scope of the disclosure as defined in the appended claims.

## Claims

1. A smart stroller, comprising:
a baby seat unit (10) provided therein with a space and including an air cleaning module (13) configured to purify air in the space; and
a cart unit (20) that supports the baby seat unit (10),
wherein the cart unit (20) comprises:
a base portion (120);
main wheels (210) rotatably coupled to a lower part of the base portion (120);
a motor (230) that is connected to the main wheels (210) to rotate the main wheels (21) together with the motor (230);
a vertical portion (110) that extends in an up-and-down direction at an upper side of the base portion (120);
a handle (130) that is rotatably coupled to an upper part of the vertical portion (110);
a pressure sensor (320) that is connected to the handle and the vertical portion (110) and senses information regarding a direction or strength of force applied to the handle (130); and
a controller (400) that is electrically connected to the motor (230) and the pressure sensor (320), and configured to receive the sensed information to calculate operation information regarding operation of the cart unit (20) using the received information.

2. The smart stroller of claim 1, wherein the cart unit (20) further comprises:
a pressure sensor accommodating portion (160) that is connected to the handle and the vertical portion (110) and accommodates the pressure sensor (320) in a space formed therein; and
a manipulation portion (170) that is rotatably coupled to the vertical portion (110) and the pressure sensor accommodating portion (160), is electrically connected to the controller (400), and receives the operation information when being rotated.

3. The smart stroller of claim 2, wherein the cart unit (20) further comprises a seat support portion (150) that is coupled to the vertical portion (110) at a lower side of the handle (130) and supports the baby seat unit (10),
wherein the baby seat unit (10) and the cart unit (20) are electrically connected to each other when the baby seat unit (10) is placed on the seat support portion (150), and
wherein the manipulation portion (170) receives operation information for controlling operation of the air cleaning module (13) when being rotated.

4. The smart stroller of any one of claims 1 to 3, wherein the cart unit (20) further comprises a display (140) that is provided at an upper end of the vertical portion (110) and is electrically connected to the controller (400) so as to output the calculated operation information.

5. The smart stroller of any one of claims 1 to 4, wherein the handle (130) is provided therein with a space,
wherein a touch sensor part that senses information regarding a distance or contact between the handle (130) and an object and is electrically connected to the controller (400) is mounted to the space, and
wherein the controller (400) is configured to calculate operation information regarding rotation of the motor (230) using the information sensed by the touch sensor part.

6. The smart stroller of any one of claims 1 to 5, wherein the cart unit (20) further comprises a dust sensor (350) that is located adjacent to an upper end of one surface of the vertical portion (110) facing the one direction in which the base portion (120) extends, among surfaces of the vertical portion (110), and
wherein the dust sensor (350) is electrically connected to the controller (400) and senses dust information regarding dust concentration in a preset space having a predetermined area with respect to the cart unit (20).

7. The smart stroller of any one of claims 1 to 6, wherein the baby seat unit (10) comprises:
a temperature sensor (361) configured to sense information regarding a temperature of the space;
a humidity sensor (362) configured to sense information regarding humidity of the space; and
an air sensor (363) configured to sense information regarding an operation state of the air cleaning module (13), and
wherein the temperature sensor (361), the humidity sensor (362), and the air sensor (363) are electrically connected to the controller (400).

8. The smart stroller of any one of claims 1 to 7, wherein the cart unit (20) further comprises a terrain sensor (340) that is located at an end, of ends in the direction in which the base portion (120) extends, of one side opposite to the vertical portion (110) and is electrically connected to the controller (400), and
wherein the terrain sensor (340) senses terrain information regarding terrain at the one side.

9. A method of controlling a smart stroller, the method comprising:
(a) sensing (S100), by a sensor part (300), information regarding operation;
(b) sensing (S200), by the sensor part (300), information regarding a surrounding environment of the smart stroller;
(c) calculating (S300), by a controller (400), operation information using the sensed information regarding the operation of the smart stroller or the sensed information regarding the surrounding environment of the smart stroller;
(d) controlling (S500), by the controller (400), the smart stroller according to the calculated operation information; and
(e) outputting (S600), by a display (140), the sensed information or the calculated operation information.

10. The method of claim 9, wherein the step (a) comprises:
(a1) sensing (S110), by a touch sensor (310), information regarding a distance between a handle (130) and an object;
(a2) sensing (S120), by a pressure sensor (320), information regarding a direction or strength of force applied to the handle (130); and
(a3) sensing (S130), by a voltage sensor (330), information regarding a voltage of a battery.

11. The method of any one of claims 9 and 10, wherein the step (b) comprises:
(b1) sensing (S210), by a terrain sensor (340), information regarding terrain in a traveling direction of the smart stroller;
(b2) sensing (S220), by a dust sensor (350), information regarding dust concentration in the surrounding environment of the smart stroller; and
(b3) sensing (s230), by a seat sensor (360), information regarding air in a space in which a baby is seated.

12. The method of any one of claims 9 to 11, wherein the step (c) comprises,
(c1) calculating (S310), by a touch information calculation module (420), touch information regarding whether the handle (130) is gripped using information sensed by a touch sensor;
(c2) calculating (S320), by a traveling information calculation module (430), traveling information regarding traveling of the smart stroller using information sensed by a pressure sensor (320) and information sensed by a voltage sensor (330);
(c3) calculating (S330), by an environment information calculation module (440), environment information regarding the surrounding environment of the smart stroller by using information sensed by a terrain sensor (340) and information sensed by a dust sensor (350); and
(c4) calculating (s340), by an internal information calculation module (450), internal information regarding air of a space in the baby seat unit (10) using information sensed by a seat sensor (360); and
(c5) calculating (S350), by an operation calculation module (460), operation information by using at least one of the calculated touch information, the traveling information, the environment information, and the internal information.

13. The method of any one of claims 9 to 12, wherein the step (d) comprises:
(d1) controlling (511), by a brake control unit (471), a brake (240) to be operated or released according to the calculated operation information;
(d2) controlling (S512), by a motor control unit (472), a motor (230) to rotate or stop according to the calculated operation information;
(d3) controlling (S513), by a suspension control unit (473), a suspension (250) such that a damping force of the suspension (250) is adjusted according to the calculated operation information; and
(d4) controlling (S514), by an air cleaning control unit (474), an air cleaning module (13) provided at a baby seat unit (10) according to the calculated operation information.

14. The method of any one of claims 9 to 13, wherein the step (e) comprises:
(e1) outputting (S610), by the display (140), information regarding a voltage of a battery, among the sensed information;
(e2) outputting (S620), by the display (140), information regarding air in a space in which a baby is seated, among the sensed information;
(e3) outputting (S630), by the display (140), information regarding operation of a brake, among the calculated operation information; and
(e4) outputting (S640), by the display (140), information regarding operation of the air cleaning module (13), among the calculated operation information.

15. The method of any one of claims 9 to 14, further comprising, before the step (d):
(f) receiving (S400), by a manipulation portion (170), operation information regarding operation of the smart stroller when being rotated,
wherein the step (f) comprises:
(f1) receiving (S410), by a first manipulation portion (171), operation information regarding operation of a motor (230) when being rotated; and
(f2) receiving (S420), by a second manipulation portion (172), operation information regarding operation of an air cleaning module (13) when being rotated, and
wherein the step (d) comprises:
(d5) controlling (S521), by a motor control unit (472), the motor to rotate or stop according to input operation information; and
(d6) controlling (S522), by an air cleaning control unit (474), the air cleaning module (13) provided at a baby seat unit (10) according to input operation information.
